# EUROPEAN PATENT APPLICATION

(11) **EP 4 780 155 A1**
(43) Date of publication of application: **22.07.2026**
(21) Application number: 25225660.7
(22) Date of filing: 19.12.2025
(51) Int. Cl.: H05K 7/20

(54) **IN-VEHICLE APPARATUS AND ELECTRIC VEHICLE**

(30) Priority: 27.12.2024 CN 202411958094
(71) Applicant: Huawei Technologies Co., Ltd., Shenzhen, Guangdong 518129 (CN)
(72) Inventor: YAO, Zirong, Shenzhen, Guangdong, 518129 (CN); WANG, Yong, Shenzhen, Guangdong, 518129 (CN); CHEN, Sen, Shenzhen, Guangdong, 518129 (CN); YE, Shuiyou, Shenzhen, Guangdong, 518129 (CN); LIAO, Weineng, Shenzhen, Guangdong, 518129 (CN); BIAN, Fei, Shenzhen, Guangdong, 518129 (CN)
(74) Representative: Maiwald GmbH

(57) **Abstract**

This application provides an in-vehicle apparatus and an electric vehicle. A housing of the in-vehicle apparatus includes an integrated housing and an electrical cover plate, the integrated housing includes an electrical accommodation groove, the electrical accommodation groove is configured to accommodate a liquid cooling plate and a water cooling radiator, the electrical cover plate is configured to fasten the liquid cooling plate, and the electrical accommodation groove is configured to fasten the water cooling radiator. A cover plate internal flow channel is configured to: receive cooling water via a cover plate water channel inlet, and deliver the cooling water to a housing water channel inlet via the cover plate water channel outlet. The cover plate internal flow channel is further configured to deliver the cooling water to an inlet of the liquid cooling plate. An internal water inlet channel is configured to: receive the cooling water via the housing water channel inlet, and deliver the cooling water to an inlet of the water cooling radiator. In this application, the in-vehicle apparatus delivers the cooling water to internal heat dissipation components via the housing, to reduce a size of the in-vehicle apparatus, thereby improving integration of the in-vehicle apparatus and miniaturizing the in-vehicle apparatus.

## Description

### TECHNICAL FIELD

This application relates to the field of electric vehicle technologies, and in particular, to an in-vehicle apparatus and an electric vehicle.

### BACKGROUND

An in-vehicle apparatus is configured to integrate an on-board charger or a motor control unit. The on-board charger is configured to: receive a high-voltage charging current to charge a power battery, and receive a current of the power battery to supply power to another load on a vehicle. The motor control unit is configured to: receive power supply from the power battery, and drive a drive motor. The on-board charger and the motor control unit generate a large amount of heat during operation. The in-vehicle apparatus needs to improve a heat dissipation capability without affecting an overall size, to ensure reliable operation of the in-vehicle apparatus.

### SUMMARY

Embodiments of this application provide an in-vehicle apparatus and an electric vehicle. The in-vehicle apparatus delivers cooling water to internal heat dissipation components via a housing, to reduce a size of the in-vehicle apparatus, thereby improving integration of the in-vehicle apparatus and miniaturizing the in-vehicle apparatus.

According to a first aspect, this application provides an in-vehicle apparatus. A housing of the in-vehicle apparatus includes an integrated housing and an electrical cover plate. The integrated housing includes an electrical accommodation groove. The electrical cover plate is configured to enclose the electrical accommodation groove. The electrical accommodation groove is configured to accommodate a liquid cooling plate and a water cooling radiator. The electrical cover plate, the liquid cooling plate, and the water cooling radiator are sequentially stacked. The electrical cover plate is configured to fasten the liquid cooling plate. The electrical accommodation groove is configured to fasten the water cooling radiator. The integrated housing includes a housing water channel inlet and an internal water inlet channel. The electrical cover plate includes a cover plate water channel inlet, a cover plate internal flow channel, and a cover plate water channel outlet. The cover plate internal flow channel is configured to: receive cooling water via the cover plate water channel inlet, and deliver the cooling water to the housing water channel inlet via the cover plate water channel outlet. The cover plate internal flow channel is further configured to deliver the cooling water to an inlet of the liquid cooling plate. The internal water inlet channel is configured to: receive the cooling water via the housing water channel inlet, and deliver the cooling water to an inlet of the water cooling radiator.

In the in-vehicle apparatus in this application, the electrical accommodation groove of the integrated housing is enclosed through the electrical cover plate, to seal and protect electrical components accommodated in the electrical accommodation groove. The in-vehicle apparatus further dissipates heat for the electrical components in the electrical accommodation groove through the liquid cooling plate and the water cooling radiator. The electrical cover plate, the liquid cooling plate, and the water cooling radiator are sequentially stacked, to form a three-layer heat dissipation structure in the electrical accommodation groove. This ensures reliable operation of the electrical components in the electrical accommodation groove.

The electrical cover plate receives the cooling water via the cover plate water channel inlet, and the electrical cover plate delivers the cooling water to the liquid cooling plate via the cover plate internal flow channel. The integrated housing receives the cooling water via the electrical cover plate. The integrated housing receives, via the housing water channel inlet, the cooling water delivered by the cover plate water channel outlet. The integrated housing delivers the cooling water to the water cooling radiator via the internal water inlet channel, and the internal water inlet channel receives the cooling water via the housing water channel inlet.

Therefore, in this application, the in-vehicle apparatus separately delivers, via the housing, the cooling water to the liquid cooling plate and the water cooling radiator, so that a water pipe structure inside the in-vehicle apparatus is omitted, and a size of the in-vehicle apparatus is reduced. The in-vehicle apparatus in this application is highly integrated, which facilitates miniaturization.

In an implementation, the electrical accommodation groove is further configured to accommodate a first circuit board, the first circuit board is arranged between the liquid cooling plate and the electrical cover plate, the electrical cover plate is configured to fasten the first circuit board, and the first circuit board is configured to fasten an electrical component of an on-board charger.

In this implementation, the first circuit board is configured to fasten the electrical component of the on-board charger, so that the in-vehicle apparatus in this application has a function of supplying power to a power battery and supplying power to another load of an electric vehicle through the power battery. The first circuit board is arranged between the liquid cooling plate and the electrical cover plate, so that the liquid cooling plate may dissipate heat for an electrical component fastened to one side of the first circuit board, and the cover plate internal flow channel may dissipate heat for an electrical component fastened to the other side of the first circuit board. In this way, the in-vehicle apparatus can achieve good heat dissipation effect for the on-board charger, to ensure reliable operation of the on-board charger.

In an implementation, a side that is of the first circuit board and that faces the liquid cooling plate is configured to fasten a plurality of power modules in electrical components of the on-board charger, a projection of the liquid cooling plate on the first circuit board covers the plurality of power modules, and an outlet of the liquid cooling plate is configured to deliver the cooling water to the cover plate internal flow channel.

In this implementation, the liquid cooling plate is configured to dissipate heat for the plurality of power modules. After the cooling water in the liquid cooling plate dissipates heat for the plurality of power modules, the cooling water further flows into the cover plate internal flow channel, so that the electrical cover plate can input the cooling water and receive the cooling water via the cover plate internal flow channel, and the cooling water can dissipate heat in the liquid cooling plate in a circulating manner, to further ensure reliable operation of the plurality of power modules of the on-board charger.

In an implementation, a side that is of the first circuit board and that faces the electrical cover plate is configured to fasten a capacitor component and an inductor component of the on-board charger, and a projection of the cover plate internal flow channel on the first circuit board covers at least a part of the capacitor component and the inductor component.

In this implementation, the cover plate internal flow channel is configured to dissipate heat for the capacitor component and the inductor component. The electrical cover plate and the liquid cooling plate jointly dissipate heat for the on-board charger, to ensure reliable operation of the on-board charger.

In an implementation, the electrical cover plate includes a cooling groove and a cooling cover plate, the cooling groove is distributed on a side that is of the electrical cover plate and that is away from the electrical accommodation groove, the cooling cover plate is configured to enclose the cooling groove to form the cover plate internal flow channel, a groove bottom of the cooling groove includes a third through hole, a fourth through hole, and a first separation protrusion, the third through hole is configured to communicate with the cover plate water channel inlet, the fourth through hole is configured to communicate with the cover plate water channel outlet, and the first separation protrusion is configured to separate the third through hole from the fourth through hole to form a U-shaped flow channel.

In this implementation, a direction of a groove opening of the cooling groove of the electrical cover plate is the same as a direction of a groove opening of the electrical accommodation groove, and the cooling cover plate covers the cooling groove to form the cover plate internal flow channel. When accidental leakage occurs in the cover plate internal flow channel, the cooling water leaks in a direction away from the electrical accommodation groove, so that the electrical components in the electrical accommodation groove can be protected. The first separation protrusion is configured to form the U-shaped flow channel in the cover plate internal flow channel, to extend a flow path of the cooling water from the third through hole to the fourth through hole, that is, extend a flow path of the cooling water in the cover plate internal flow channel. In this way, the cooling water in the cover plate internal flow channel exchanges sufficient heat with the on-board charger, to improve heat dissipation effect.

In an implementation, the groove bottom of the cooling groove includes a first through hole, a second through hole, and a second separation protrusion, the first through hole and the second through hole separately penetrate the groove bottom of the cooling groove, the first through hole is configured to communicate with the inlet of the liquid cooling plate, the second through hole is configured to communicate with the outlet of the liquid cooling plate, the second separation protrusion is configured to separate the first through hole from the second through hole, the third through hole and the first through hole are arranged between the first separation protrusion and the second separation protrusion, the first through hole and the third through hole are arranged on one side of the second separation protrusion, and the second through hole is arranged on the other side of the second separation protrusion.

In this implementation, the cooling groove communicates with the liquid cooling plate via the first through hole and the second through hole, to circulate the cooling water to the liquid cooling plate. The third through hole and the first through hole are arranged between the first separation protrusion and the second separation protrusion, and the second separation protrusion is configured to separate the first through hole from the second through hole, so that the cooling water that enters the cover plate internal flow channel from the cover plate water channel inlet via the third through hole first flows into the liquid cooling plate from the first through hole, then flows back to the cover plate internal flow channel via the second through hole, and then flows into the housing water channel inlet from the cover plate water channel outlet via the fourth through hole. Such an arrangement manner can ensure that a temperature of the cooling water flowing into the liquid cooling plate is low, and improve heat dissipation effect of the liquid cooling plate on the plurality of power modules.

In an implementation, the groove bottom of the cooling groove further includes a plurality of heat dissipation fins and a plurality of flow-guiding fins. The plurality of heat dissipation fins are distributed on two sides of the first separation protrusion, the plurality of flow-guiding fins are distributed on the two sides of the first separation protrusion, and at least one of quantities, shapes, or arrangement manners of at least one of the flow-guiding fins or the heat dissipation fins on the two sides of the first separation protrusion is different.

In this implementation, the plurality of heat dissipation fins are configured to slow down a flow rate of the cooling water in the cover plate internal flow channel, to improve heat exchange effect when the cooling water flows through the plurality of heat dissipation fins, and the plurality of flow-guiding fins are configured to guide the cooling water to flow along a flow path in the cover plate internal flow channel. The plurality of heat dissipation fins and the plurality of flow-guiding fins are alternately arranged in the cover plate internal flow channel, so that heat dissipation regions of different quantities, different sizes, and different regions may be formed in the cover plate internal flow channel, and each heat dissipation region is individually matched to a quantity, shapes, and locations of electrical components of the on-board charger.

In an implementation, the electrical cover plate includes a connection post, the connection post extends toward the liquid cooling plate, a surface that is of the connection post and that faces the liquid cooling plate includes a groove, the groove is configured to accommodate a heat dissipation panel water nozzle of the liquid cooling plate, the first through hole penetrates the groove bottom of the cooling groove and a groove bottom of the groove and is connected to the inlet of the liquid cooling plate, and the second through hole penetrates the groove bottom of the cooling groove and the groove bottom of the groove and is connected to the outlet of the liquid cooling plate.

In this implementation, the liquid cooling plate and the electrical cover plate are spaced from each other, and the electrical cover plate extends toward the liquid cooling plate through the connection post at the groove bottom of the cooling groove, to fasten and communicate with the heat dissipation panel water nozzle of the liquid cooling plate. The groove on the surface that is of the connection post and that faces the liquid cooling plate is configured to increase a contact area between the connection post and the heat dissipation panel water nozzle, to ensure a reliable connection and facilitate sealing, thereby ensuring that the inlet and the outlet of the liquid cooling plate are reliably connected to the first through hole and the second through hole respectively.

In an implementation, the housing water channel inlet is distributed on an outer side of the electrical accommodation groove, the cover plate water channel inlet and the cover plate water channel outlet are distributed on a side that is of the electrical cover plate and that faces the electrical accommodation groove, an orientation of the cover plate water channel inlet is opposite to an orientation of a groove opening of the electrical accommodation groove, and an orientation of the housing water channel inlet is the same as the orientation of the groove opening of the electrical accommodation groove.

In this implementation, a direction of the cover plate water channel inlet is opposite to the orientation of the groove opening of the electrical accommodation groove, a water pipe of a water cooling system communicates with the cover plate water channel inlet in a direction from the integrated housing to the electrical cover plate, and the water pipe and the integrated housing are adjacently arranged. In this way, the water pipe does not occupy space on a side that is of the electrical cover plate and that is away from the integrated housing, and an overall height of the housing of the in-vehicle apparatus can be controlled. Because the cover plate water channel outlet and the housing water channel inlet face opposite directions, it is convenient for the integrated housing to receive the cooling water via the electrical cover plate.

In an implementation, the integrated housing includes the internal water inlet channel and a first groove bottom water channel interface, the internal water inlet channel is configured for communication of the housing water channel inlet and the first groove bottom water channel interface, and the inlet of the water cooling radiator is configured to receive, via the first groove bottom water channel interface, the cooling water input from the housing water channel inlet. An orientation of the first groove bottom water channel interface is the same as the orientation of the groove opening of the electrical accommodation groove, an orientation of the inlet of the water cooling radiator is opposite to the orientation of the groove opening of the electrical accommodation groove, and the inlet of the water cooling radiator is configured to be embedded into the first groove bottom water channel interface.

In this implementation, the internal water inlet channel is configured to deliver the cooling water to the first groove bottom water channel interface, and the water cooling radiator is configured to receive, via the first groove bottom water channel interface, the cooling water delivered by the integrated housing. The inlet of the water cooling radiator is further configured to be embedded into the first groove bottom water channel interface, to be connected to the first groove bottom water channel interface. The first groove bottom water channel interface is further configured to fasten the water cooling radiator.

In an implementation, the integrated housing includes a second groove bottom water channel interface, an internal water outlet channel, and a housing water channel outlet, the internal water outlet channel is configured for communication of the second groove bottom water channel interface and the housing water channel outlet, and the outlet of the water cooling radiator is configured to deliver the cooling water to the housing water channel outlet via the second groove bottom water channel interface. An orientation of the second groove bottom water channel interface is the same as the orientation of the groove opening of the electrical accommodation groove, an orientation of the outlet of the water cooling radiator is opposite to the orientation of the groove opening of the electrical accommodation groove, and the outlet of the water cooling radiator is configured to be embedded into the second groove bottom water channel interface.

In this implementation, the water cooling radiator is configured to output the cooling water via the integrated housing, to implement a circulating heat dissipation function of the internal cooling water. The outlet of the water cooling radiator is configured to be embedded into the second groove bottom water channel interface and connected to the second groove bottom water channel interface. The second groove bottom water channel interface is further configured to fasten the water cooling radiator. The internal water outlet channel is configured to receive, via the second groove bottom water channel interface, the cooling water flowing out of the water cooling radiator, and the internal water outlet channel is configured to output the cooling water via the housing water channel outlet.

Therefore, the in-vehicle apparatus provided in this application can receive, via the cover plate water channel inlet, the cooling water delivered by the water cooling system of the vehicle, separately deliver the cooling water to the water cooling radiator and the liquid cooling plate via the housing internal flow channel, receive the cooling water flowing out of the water cooling radiator and the liquid cooling plate via the housing internal flow channel, and then deliver the cooling water back to the water cooling system via the housing water channel outlet to dissipate heat, thereby dissipating heat for the electrical components accommodated in the electrical accommodation groove in a circulating manner.

In an implementation, the housing water channel inlet and the housing water channel outlet are distributed on a same side outside the electrical accommodation groove, and an orientation of the housing water channel outlet is different from an orientation of the housing water channel inlet.

In this implementation, the housing water channel inlet and the cover plate water channel inlet are located on a same side of the electrical accommodation groove, and the housing water channel outlet and the cover plate water channel inlet are also located on a same side of the electrical accommodation groove. On a same side of the housing of the in-vehicle apparatus, water pipes of the water cooling system of the electric vehicle respectively inputs the cooling water to the housing and receives the cooling water output from the housing. The two water pipes of the water cooling system occupy space on a same side of the housing of the in-vehicle apparatus, so that an overall width of the housing of the in-vehicle apparatus can be controlled.

In an implementation, the electrical accommodation groove is further configured to accommodate a second circuit board, the second circuit board is arranged between the water cooling radiator and the liquid cooling plate, the water cooling radiator is configured to fasten the second circuit board, and the second circuit board is configured to fasten an electrical component of a motor control unit.

In this implementation, the second circuit board is configured to fasten the electrical component of the motor control unit, so that the in-vehicle apparatus in this application has a function of receiving power supplied by the power battery and driving a drive motor. The second circuit board is arranged between the liquid cooling plate and the water cooling radiator, so that the liquid cooling plate may dissipate heat for an electrical component fastened to one side of the second circuit board, and the water cooling radiator may dissipate heat for an electrical component fastened to the other side of the second circuit board. In this way, the in-vehicle apparatus can achieve good heat dissipation effect for the motor control unit, to ensure reliable operation of the on-board charger.

In this application, the in-vehicle apparatus delivers the cooling water to the liquid cooling plate via the electrical cover plate, and then delivers the cooling water to the water cooling radiator via the electrical cover plate and the integrated housing. The cooling water first flows through the liquid cooling plate and the cover plate internal flow channel in the housing to dissipate heat for the on-board charger, and then flows through the water cooling radiator to dissipate heat for the motor control unit. The on-board charger generates a large amount of heat in a process of charging the power battery, and in a process of charging the power battery, the motor control unit does not operate or generates a small amount of heat when operating. Therefore, the cooling water in the housing preferentially dissipates heat for the on-board charger. However, when the motor control unit receives power supplied by the power battery to drive the electric vehicle, the on-board charger does not operate or generates a small amount of heat when operating, a heating temperature of the cooling water flowing through the on-board charger is low, and the cooling water in the housing dissipates more heat for the motor control unit. In the in-vehicle apparatus in this application, the housing internal flow channel, the liquid cooling plate, and the water cooling radiator are arranged with reference to respective operating characteristics of the on-board charger and the motor control unit, to ensure reliable operation of the on-board charger and the motor control unit while reducing a size.

In an implementation, the electrical component of the motor control unit is configured to control a three-phase inverter circuit in the electrical component of the motor control unit, the three-phase inverter circuit includes a bus capacitor module, the bus capacitor module is arranged on a side that is of the water cooling radiator and that is away from the second circuit board, and the water cooling radiator is configured to fasten the bus capacitor module.

In this implementation, the motor control unit and the water cooling radiator are fastened together to the integrated housing, to simplify assembly of the in-vehicle apparatus. The water cooling radiator is located between the bus capacitor module and the second circuit board, so that two opposite surfaces of the water cooling radiator may respectively dissipate heat for the bus capacitor module and the electrical component on the second circuit board.

In an implementation, the three-phase inverter circuit includes a plurality of second power modules, and the plurality of second power modules are arranged between the second circuit board and the bus capacitor module. The water cooling radiator includes a first heat dissipation panel and a second heat dissipation panel that are stacked. The first heat dissipation panel and the second heat dissipation panel are connected in parallel between the inlet and the outlet of the water cooling radiator. The first heat dissipation panel is arranged between the second power modules and the second circuit board. The second heat dissipation panel is arranged between the second power modules and the bus capacitor module.

In this implementation, the water cooling radiator is arranged on two sides of the second power modules through the first heat dissipation panel and the second heat dissipation panel, to ensure heat dissipation effect on the second power modules, thereby ensuring reliable operation of the motor control unit.

In an implementation, the electrical cover plate is configured to fasten a water channel communication component, the water channel communication component includes two ends, one of the two ends of the water channel communication component is configured to enclose the cover plate water channel inlet, the other of the two ends of the water channel communication component is configured to receive, via a water pipe, the cooling water delivered by the water cooling system of the electric vehicle, and the housing water channel outlet of the integrated housing is configured to deliver the cooling water to the water cooling system of the electric vehicle via the water pipe.

In this implementation, the electrical cover plate is roughly plate-shaped, and the electrical cover plate communicates with the water pipe of the water cooling system via the water channel communication component. This helps implement a sealing fit between the electrical cover plate and the water pipe through the water channel communication component. The housing water channel outlet may be constructed in a water nozzle form, to directly communicate with and form a sealing fit with the water pipe of the water cooling system.

In an implementation, the in-vehicle apparatus further includes a drive motor and a reducer, the housing of the in-vehicle apparatus further includes a motor end cover and a reducer end cover, the integrated housing further includes a motor accommodation groove and a reducer accommodation groove, the motor accommodation groove is configured to fasten and accommodate a stator of the drive motor, the motor end cover is configured to enclose the motor accommodation groove, the reducer accommodation groove is configured to accommodate a gear set of the reducer, and the reducer end cover is configured to enclose the reducer accommodation groove. The motor accommodation groove and the reducer accommodation groove are adjacently arranged in an axial direction of the drive motor, an orientation of a groove opening of the motor accommodation groove is opposite to an orientation of a groove opening of the reducer accommodation groove, and the orientation of the groove opening of the electrical accommodation groove is perpendicular to the orientation of the groove opening of the motor accommodation groove and the orientation of the groove opening of the reducer accommodation groove.

In this implementation, the integrated housing of the in-vehicle apparatus in this application further includes the motor accommodation groove and the reducer accommodation groove, the integrated housing is configured to fasten the stator of the drive motor, the motor end cover and the reducer end cover are configured to fasten a transmission shaft of the reducer through a bearing, the motor accommodation groove can accommodate the drive motor, and the reducer accommodation groove can accommodate the gear set of the reducer. In this way, the in-vehicle apparatus in this application is further integrated.

The orientation of the groove opening of the motor accommodation groove is opposite to the orientation of the groove opening of the reducer accommodation groove, and the drive motor and the reducer are adjacently arranged in the axial direction of the drive motor. In this way, a length size of the in-vehicle apparatus in this application in the axial direction of the drive motor can be reduced. The orientation of the groove opening of the electrical accommodation groove is perpendicular to the orientation of the groove opening of the motor accommodation groove and the orientation of the groove opening of the reducer accommodation groove, and the electrical cover plate of the in-vehicle apparatus is parallel to the axial direction of the drive motor, and is closer to an axis of the drive motor. In this way, a height size of the in-vehicle apparatus in this application in a direction perpendicular to the electrical cover plate can be reduced, and an overall size of the in-vehicle apparatus in this application can be further reduced.

In an implementation, a groove wall of the electrical accommodation groove includes a first section of the groove wall, a second section of the groove wall, a third section of the groove wall, and a fourth section of the groove wall, the first section of the groove wall and the second section of the groove wall are arranged opposite to each other in the axial direction of the drive motor, the third section of the groove wall and the fourth section of the groove wall are arranged opposite to each other in a direction perpendicular to the axial direction of the drive motor, a spacing between the first section of the groove wall and the groove opening of the motor accommodation groove is greater than a spacing between the second section of the groove wall and the groove opening of the motor accommodation groove, a spacing between the third section of the groove wall and a motor shaft of the drive motor is less than a spacing between the fourth section of the groove wall and the motor shaft of the drive motor, a power battery interface of the in-vehicle apparatus is distributed on the first section of the groove wall, a load power supply interface of the in-vehicle apparatus is distributed on the second section of the groove wall, a control signal interface of the in-vehicle apparatus is distributed on the third section of the groove wall, and the housing water channel outlet and the housing water channel inlet are distributed on an outer side of the fourth section of the groove wall.

In this implementation, the second section of the groove wall and the first section of the groove wall are sequentially arranged in a direction from the motor end cover to the reducer end cover. The in-vehicle apparatus receives power supply from the power battery or supplies power to the power battery via the power battery interface on the first section of the groove wall, and the in-vehicle apparatus supplies power to a load of the electric vehicle via the load power supply interface on the second section of the groove wall.

In the direction perpendicular to the axial direction of the drive motor, the fourth section of the groove wall is offset toward one side of the drive motor relative to the third section of the groove wall, and the fourth section of the groove wall and an output gear that is in the gear set of the reducer and that is configured to output power are adjacently arranged in the axial direction of the drive motor, so that space on a side that is of the drive motor and that faces the output gear of the reducer can be fully utilized for the electrical accommodation groove, to reduce an overall width size of the in-vehicle apparatus. The in-vehicle apparatus receives or sends a control signal of the electric vehicle through the control signal interface on the third section of the groove wall, and the in-vehicle apparatus receives, via the cover plate water channel inlet on the fourth section of the groove wall, the cooling water delivered by the water cooling system, and delivers the cooling water to the cooling system via the housing water channel outlet on the fourth section of the groove wall.

According to a second aspect, this application provides an electric vehicle. The electric vehicle includes a power battery and the in-vehicle apparatus provided in any one of the foregoing implementations, and the in-vehicle apparatus is configured to charge a power battery or drive wheels by using power supplied by the power battery.

The electric vehicle provided in the second aspect of this application has smaller internal space because the electric vehicle includes the foregoing in-vehicle apparatus. This helps improve integration of the electric vehicle and facilitates miniaturization.

### BRIEF DESCRIPTION OF DRAWINGS

To describe the technical solutions in embodiments of this application more clearly, the following describes the accompanying drawings used in embodiments of this application.
FIG. 1 is a diagram of a structure of an electric vehicle 200 according to an embodiment of this application;
FIG. 2 is a logical diagram of internal power supply of an electric vehicle 200 according to an embodiment of this application;
FIG. 3 is a diagram of internal components of an in-vehicle apparatus 100 according to an embodiment of this application;
FIG. 4 is a diagram of an appearance structure of an in-vehicle apparatus 100 according to an embodiment of this application;
FIG. 5 is a diagram of an exploded structure of an in-vehicle apparatus 100 according to an embodiment of this application;
FIG. 6 is a diagram of a partial structure of an in-vehicle apparatus 100 according to an embodiment of this application;
FIG. 7 is a diagram of a partial structure of an in-vehicle apparatus 100 according to an embodiment of this application;
FIG. 8 is a diagram of a partial exploded structure of an in-vehicle apparatus 100 according to an embodiment of this application;
FIG. 9 is a diagram of a partial structure of an in-vehicle apparatus 100 according to an embodiment of this application;
FIG. 10 is a diagram of an exploded structure of an in-vehicle apparatus 100 according to an embodiment of this application;
FIG. 11 is a diagram of an exploded structure of an in-vehicle apparatus 100 according to an embodiment of this application;
FIG. 12 is a diagram of a partial structure of an in-vehicle apparatus 100 according to an embodiment of this application;
FIG. 13 is a diagram of an exploded structure of an in-vehicle apparatus 100 according to an embodiment of this application;
FIG. 14 is a diagram of a plane structure of an in-vehicle apparatus 100 according to an embodiment of this application;
FIG. 15 is a diagram of a partial structure of an in-vehicle apparatus 100 according to an embodiment of this application;
FIG. 16 is a diagram of an exploded structure of an in-vehicle apparatus 100 according to an embodiment of this application;
FIG. 17 is a diagram of a partial structure of an in-vehicle apparatus 100 according to an embodiment of this application;
FIG. 18 is a diagram of a partial structure of an in-vehicle apparatus 100 according to an embodiment of this application;
FIG. 19 is a diagram of a partial structure of an in-vehicle apparatus 100 according to an embodiment of this application;
FIG. 20 is a diagram of an exploded structure of an in-vehicle apparatus 100 according to an embodiment of this application;
FIG. 21 is a diagram of a partial structure of an in-vehicle apparatus 100 according to an embodiment of this application;
FIG. 22 is a diagram of an exploded structure of an in-vehicle apparatus 100 according to an embodiment of this application;
FIG. 23 is a diagram of an exploded structure of an in-vehicle apparatus 100 according to an embodiment of this application;
FIG. 24 is a diagram of a cross-sectional structure of an in-vehicle apparatus 100 according to an embodiment of this application;
FIG. 25 is a diagram of a cross-sectional structure of an in-vehicle apparatus 100 according to an embodiment of this application;
FIG. 26 is a diagram of a cross-sectional structure of an in-vehicle apparatus 100 according to an embodiment of this application;
FIG. 27 is a diagram of a cross-sectional structure of an in-vehicle apparatus 100 according to an embodiment of this application;
FIG. 28 is a diagram of a partial structure of an in-vehicle apparatus 100 according to an embodiment of this application;
FIG. 29 is a diagram of an exploded structure of an in-vehicle apparatus 100 according to an embodiment of this application;
FIG. 30 is a diagram of an exploded structure of an in-vehicle apparatus 100 according to an embodiment of this application;
FIG. 31 is a diagram of a cross-sectional structure of an in-vehicle apparatus 100 according to an embodiment of this application;
FIG. 32 is a diagram of a structure of an in-vehicle apparatus 100 according to an embodiment of this application;
FIG. 33 is a diagram of an exploded structure of an in-vehicle apparatus 100 according to an embodiment of this application;
FIG. 34 is a diagram of a structure of an in-vehicle apparatus 100 according to an embodiment of this application;
FIG. 35 is a diagram of an exploded structure of an in-vehicle apparatus 100 according to an embodiment of this application;
FIG. 36 is a diagram of a structure of an in-vehicle apparatus 100 according to an embodiment of this application;
FIG. 37 is a diagram of a structure of an in-vehicle apparatus 100 according to an embodiment of this application;
FIG. 38 is a diagram of a partial structure of an in-vehicle apparatus 100 according to an embodiment of this application;
FIG. 39 is a diagram of a partial structure of an in-vehicle apparatus 100 according to an embodiment of this application; and
FIG. 40 is a diagram of a partial exploded structure of an in-vehicle apparatus 100 according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application. All other embodiments obtained by persons of ordinary skill in the art based on embodiments of this application without creative efforts shall fall within the protection scope of this application.

For ease of understanding, the following first explains and describes English abbreviations and related technical terms in embodiments of this application.

OBC: On-board charger. The on-board charger is a power electronic apparatus that converts an alternating current into a direct current to charge a power battery of a vehicle.

ACDC: Alternating current to direct current. An alternating current conversion circuit can convert an alternating current into a direct current, or convert a direct current into an alternating current, for example, may convert an external high-voltage charging current into a high-voltage direct current to charge the power battery of the vehicle, or convert a high-voltage direct current of the power battery into a high-voltage alternating current to supply power to a drive motor.

DCDC: Direct current to direct current. A direct current conversion circuit can convert a direct current at a voltage level into a direct current at another voltage level, to adjust power output and stabilize a power voltage, for example, may convert a high-voltage direct current output by the power battery of the vehicle into a low-voltage direct current to supply power to another electrical component in the vehicle.

MCU: Motor control unit. The motor control unit receives a control instruction from a vehicle control unit to control a rotation speed and a rotation direction of the drive motor.

In this specification, a "high voltage" and a "low voltage" indicate relative voltage values, a voltage of the "high voltage" is higher than a voltage of the "low voltage", and the "high voltage" and the "low voltage" do not indicate specific voltage values.

This application provides an in-vehicle apparatus. A housing of the in-vehicle apparatus includes an integrated housing and an electrical cover plate. The integrated housing includes an electrical accommodation groove. The electrical cover plate is configured to enclose the electrical accommodation groove. The electrical accommodation groove is configured to accommodate a liquid cooling plate and a water cooling radiator. The electrical cover plate, the liquid cooling plate, and the water cooling radiator are sequentially stacked. The electrical cover plate is configured to fasten the liquid cooling plate. The electrical accommodation groove is configured to fasten the water cooling radiator. The integrated housing includes a housing water channel inlet and an internal water inlet channel. The electrical cover plate includes a cover plate water channel inlet, a cover plate internal flow channel, and a cover plate water channel outlet. The cover plate internal flow channel is configured to: receive cooling water via the cover plate water channel inlet, and deliver the cooling water to the housing water channel inlet via the cover plate water channel outlet. The cover plate internal flow channel is further configured to deliver the cooling water to an inlet of the liquid cooling plate. The internal water inlet channel is configured to: receive the cooling water via the housing water channel inlet, and deliver the cooling water to an inlet of the water cooling radiator. In this application, the in-vehicle apparatus separately delivers, via the housing, the cooling water to the liquid cooling plate and the water cooling radiator, so that a water pipe structure inside the in-vehicle apparatus is omitted, and a size of the in-vehicle apparatus is reduced. The in-vehicle apparatus in this application is highly integrated, which facilitates miniaturization.

This application provides an electric vehicle. The electric vehicle includes a power battery and the in-vehicle apparatus provided in this application, and the in-vehicle apparatus is configured to charge a power battery or drive wheels by using power supplied by the power battery. Internal space of the electric vehicle provided in this application is more compact. This helps improve miniaturization of the electric vehicle.

The electric vehicle provided in this application includes an electric car/electric vehicle (Electric Vehicle, EV for short), a pure electric vehicle (Pure Electric Vehicle/Battery Electric Vehicle, PEV/BEV for short), a hybrid electric vehicle (Hybrid Electric Vehicle, HEV for short), a range extended electric vehicle (Range Extended Electric Vehicle, REEV for short), a plug-in hybrid electric vehicle (Plug-in Hybrid Electric Vehicle, PHEV for short), a new energy vehicle (New Energy Vehicle), and the like. In some implementations, the electric vehicle includes a passenger vehicle and various special operation vehicles with specific functions, for example, an engineering rescue vehicle, a sprinkler, a sewage sucker, a cement mixer, a crane, and a medical vehicle. The electric vehicle may alternatively be a robot that can travel.

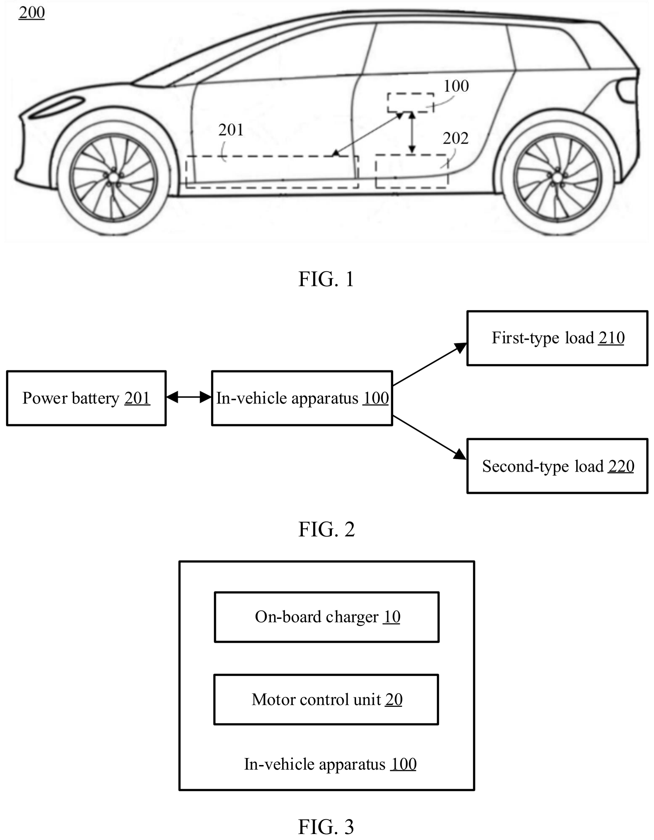

FIG. 1 is a diagram of a structure of an electric vehicle 200 according to an embodiment of this application, and FIG. 2 is a logical diagram of internal power supply of the electric vehicle 200 according to an embodiment of this application.

As shown in FIG. 1, the electric vehicle 200 provided in this application includes a power battery 201 and an in-vehicle apparatus 100 provided in this application. The power battery 201 and the in-vehicle apparatus 100 are separately fastened to a frame of the electric vehicle 200. The in-vehicle apparatus 100 is configured to be electrically connected to the power battery 201. The power battery 201 is configured to supply power to electrical components of the electric vehicle 200. The electrical components of the electric vehicle 200 include a first-type load 210 and a second-type load 220. The first-type load 210 is a high-voltage load, for example, a compressor and a heater of the electric vehicle 200. The second-type load 220 is a low-voltage load, for example, at least one of a low-voltage battery, a light, a wiper, an air conditioner, a speaker, a USB interface, a dashboard, and a control display screen. The low-voltage battery may also supply power to another load in the second-type load 220.

A current output by the power battery 201 is a high-voltage direct current. The power battery 201 may directly supply power to the first-type load 210, and supply power to the second-type load 220 through the in-vehicle apparatus 100 provided in this application. In some embodiments, the power battery 201 may also supply power to the first-type load 210 through the in-vehicle apparatus 100 provided in this application.

In an embodiment, the electric vehicle 200 provided in this application includes a drive motor 202. The drive motor 202 is configured to drive wheels of the electric vehicle 200 to rotate. The drive motor 202 belongs to the first-type load 210. An operating current of the drive motor 202 is a high-voltage alternating current. The power battery 201 supplies power to the drive motor 202 through the in-vehicle apparatus 100 provided in this application. In other words, the in-vehicle apparatus 100 provided in this application is configured to: receive a high-voltage direct current input by the power battery 201, and convert the high-voltage direct current into a high-voltage alternating current to supply power to the drive motor 202.

The in-vehicle apparatus 100 is configured to charge/discharge the power battery 201 or supply power to the drive motor 202. The in-vehicle apparatus 100 receives a high-voltage charging current through an external power supply. In an embodiment, the external power supply may be an alternating current power grid, an alternating current charging pile, or an uninterruptible power system (Uninterruptible Power System, UPS). In this case, the external power supply is an alternating current power supply. The in-vehicle apparatus 100 is configured to: electrically connect to the external power supply, and receive a high-voltage alternating current. The in-vehicle apparatus 100 converts the received high-voltage alternating current into a high-voltage direct current and transmits the high-voltage direct current to the power battery 201, to implement a charging and discharging function.

In an embodiment, the in-vehicle apparatus 100 provided in this application performs voltage amplitude or frequency conversion on the received high-voltage alternating current, and outputs another form of alternating current to supply power to another electrical component that needs to operate on the alternating current.

FIG. 3 is a diagram of internal components of the in-vehicle apparatus 100 according to an embodiment of this application.

In an embodiment, the in-vehicle apparatus 100 provided in this application includes at least one of an on-board charger 10 and a motor control unit 20. The on-board charger 10 is configured to: receive a high-voltage charging current, convert the high-voltage charging current into a high-voltage direct current, and transmit the high-voltage direct current to the power battery 201. The on-board charger 10 is further configured to: receive a high-voltage direct current input by the power battery 201, and convert the high-voltage direct current into a low-voltage direct current to supply power to the second-type load 220 of the electric vehicle 200.

In an embodiment, the on-board charger 10 includes an alternating current conversion circuit and a direct current conversion circuit. The alternating current conversion circuit is configured to: receive a high-voltage charging current, and convert the high-voltage charging current into a direct current to supply power to the power battery 201. The direct current conversion circuit is configured to: receive a high-voltage direct current of the power battery 201, and convert the high-voltage direct current into a low-voltage direct current to supply power to the second-type load 220 of the electric vehicle 200. The motor control unit 20 is configured to: receive a high-voltage direct current input by the power battery 201, and convert the high-voltage direct current into a high-voltage alternating current to supply power to the drive motor 202. The motor control unit 20 also includes an alternating current conversion circuit.

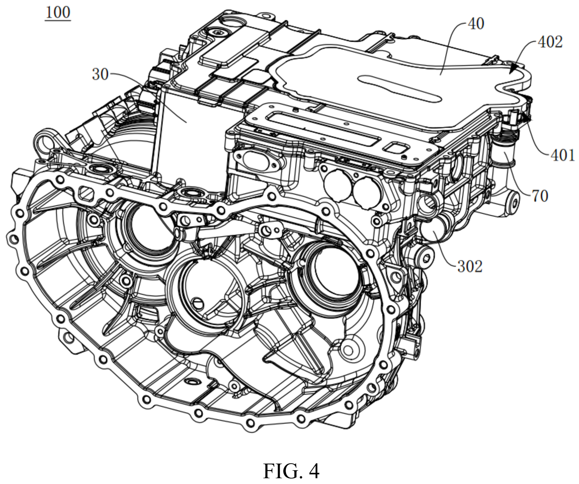

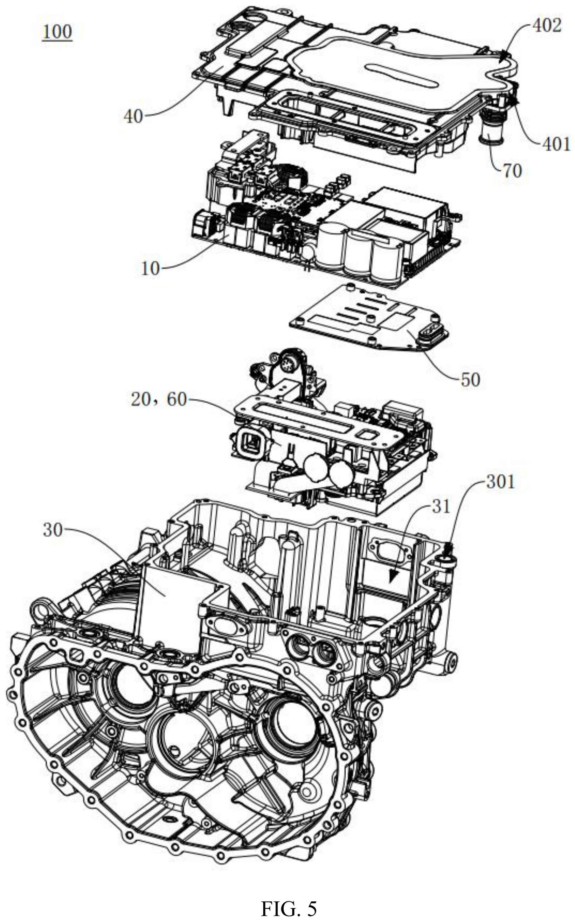

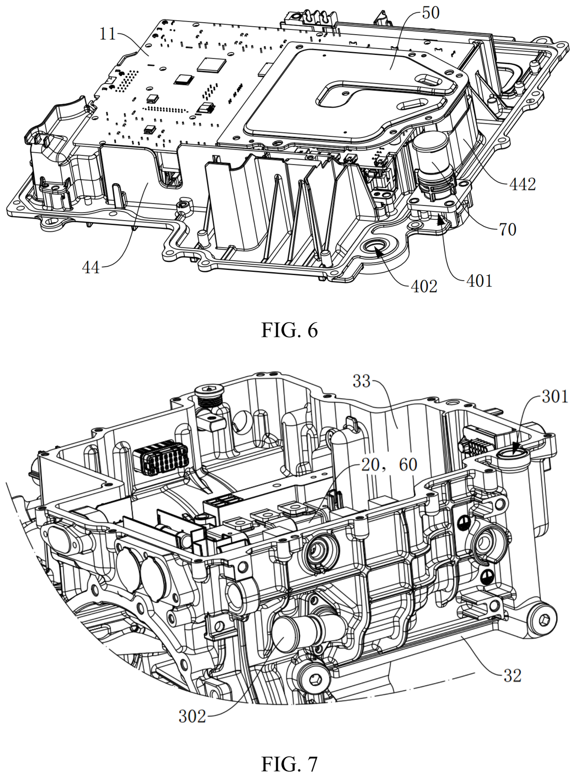

FIG. 4 is a diagram of an appearance structure of the in-vehicle apparatus 100 according to an embodiment of this application, FIG. 5 is a diagram of an exploded structure of the in-vehicle apparatus 100 according to an embodiment of this application, and FIG. 6 is a diagram of a partial structure of the in-vehicle apparatus 100 according to an embodiment of this application.

The in-vehicle apparatus 100 provided in this application includes a housing and an electrical component. The housing includes an integrated housing 30 and an electrical cover plate 40, the integrated housing 30 includes an electrical accommodation groove 31, and the electrical component of the in-vehicle apparatus 100 is accommodated in the electrical accommodation groove 31. The electrical cover plate 40 is configured to enclose the electrical accommodation groove 31. In an embodiment, the electrical component of the in-vehicle apparatus 100 includes at least one of the on-board charger 10 and the motor control unit 20. In other words, the electrical accommodation groove 31 is configured to accommodate an electrical component of at least one of the on-board charger 10 or the motor control unit 20.

The electrical accommodation groove 31 is configured to accommodate a liquid cooling plate 50 and the water cooling radiator 60. The electrical cover plate 40, the liquid cooling plate 50, and the water cooling radiator 60 are sequentially stacked. The electrical cover plate 40 is configured to fasten the liquid cooling plate 50. The electrical accommodation groove 31 is configured to fasten the water cooling radiator 60. The integrated housing 30 includes a housing water channel inlet 301 and an internal water inlet channel. The electrical cover plate 40 includes a cover plate water channel inlet 401, a cover plate internal flow channel, and a cover plate water channel outlet 402. The cover plate internal flow channel is configured to: receive cooling water via the cover plate water channel inlet 401, and deliver the cooling water to the housing water channel inlet 301 via the cover plate water channel outlet 402. The cover plate internal flow channel is further configured to deliver the cooling water to an inlet of the liquid cooling plate 50. The internal water inlet channel is configured to: receive the cooling water via the housing water channel inlet 301, and deliver the cooling water to an inlet of the water cooling radiator 60.

In the in-vehicle apparatus 100 in this application, the electrical accommodation groove 31 of the integrated housing 30 is enclosed through the electrical cover plate 40, to seal and protect the electrical components accommodated in the electrical accommodation groove 31. The in-vehicle apparatus 100 further dissipates heat for the electrical component in the electrical accommodation groove 31 through the liquid cooling plate 50 and the water cooling radiator 60. The electrical cover plate 40, the liquid cooling plate 50, and the water cooling radiator 60 are sequentially stacked, to form a three-layer heat dissipation structure in the electrical accommodation groove 31. This ensures reliable operation of the electrical component in the electrical accommodation groove 31.

In an embodiment, the electrical accommodation groove 31 of the in-vehicle apparatus 100 is configured to accommodate the on-board charger 10 and the motor control unit 20 in the electrical accommodation groove 31, and the on-board charger 10 is located between the electrical cover plate 40 and the motor control unit 20. In the in-vehicle apparatus 100, the electrical cover plate 40 further forms a part of a cooling water flow channel. The electrical cover plate 40 receives, via the cover plate water channel inlet 401, the cooling water delivered by a water cooling system of the electric vehicle 200, and supplies the cooling water to the integrated housing 30 via the cover plate water channel outlet 402 and the housing water channel inlet 301 that are opposite to each other. When the cooling water flows into the cover plate internal flow channel of the electrical cover plate 40, the cooling water may dissipate heat for the on-board charger 10 or the motor control unit 20 in the electrical accommodation groove 31. After the cooling water flows into the integrated housing 30, the cooling water may continue to dissipate heat for the on-board charger 10 or the motor control unit 20, to ensure reliable operation of the in-vehicle apparatus 100.

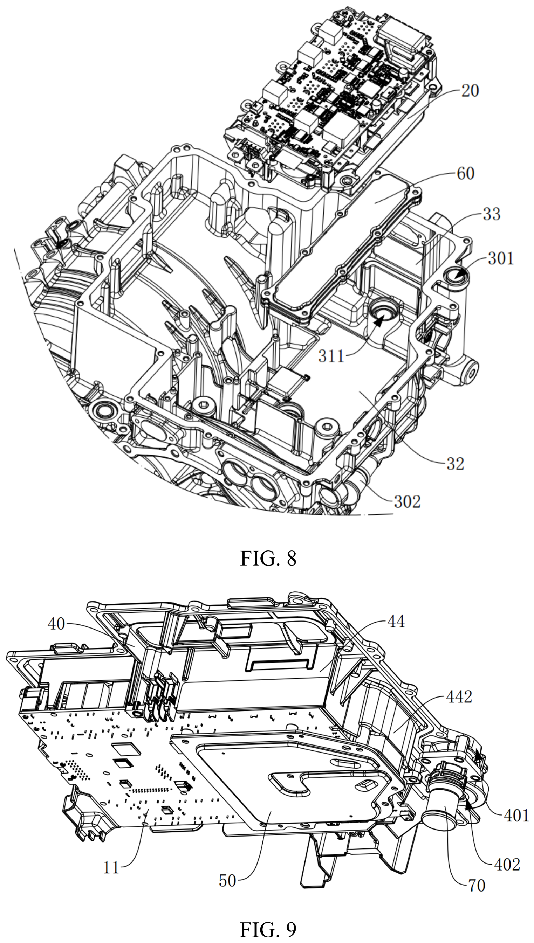

FIG. 7 is a diagram of a partial structure of the in-vehicle apparatus 100 according to an embodiment of this application, and FIG. 8 is a diagram of a partial exploded structure of the in-vehicle apparatus 100 according to an embodiment of this application.

The electrical cover plate 40 receives the cooling water via the cover plate water channel inlet 401, and the electrical cover plate 40 delivers the cooling water to the liquid cooling plate 50 via the cover plate internal flow channel. The integrated housing 30 receives the cooling water via the electrical cover plate 40. The integrated housing 30 receives, via the housing water channel inlet 301, the cooling water delivered by the cover plate water channel outlet 402. The integrated housing 30 delivers the cooling water to the water cooling radiator 60 via the internal water inlet channel, and the internal water inlet channel receives the cooling water via the housing water channel inlet 301.

Therefore, in this application, the in-vehicle apparatus 100 separately delivers, via the housing, the cooling water to the liquid cooling plate 50 and the water cooling radiator 60, so that a water pipe structure inside the in-vehicle apparatus 100 is omitted, and a size of the in-vehicle apparatus 100 is reduced. The in-vehicle apparatus 100 in this application is highly integrated, which facilitates miniaturization. The electric vehicle 200 provided in this application has smaller internal space because the electric vehicle 200 includes the in-vehicle apparatus 100. This helps improve integration of the electric vehicle 200 and facilitates miniaturization.

In embodiments of this application, the cooling water in the in-vehicle apparatus 100 may be coolant or cooling oil.

In embodiments of this application, an arrangement direction of the integrated housing 30 and the electrical cover plate 40 is defined as a height direction of the in-vehicle apparatus 100, and a direction perpendicular to the height direction of the in-vehicle apparatus 100 is defined as a plane direction of the in-vehicle apparatus 100. The on-board charger 10 and the motor control unit 20 in the electrical accommodation groove 31 are spaced from each other in the height direction of the in-vehicle apparatus 100. The water cooling radiator 60, the liquid cooling plate 50, and the electrical cover plate 40 are sequentially stacked in the height direction of the in-vehicle apparatus 100. The integrated housing 30 is configured to fasten the water cooling radiator 60 and the electrical cover plate 40, and the electrical cover plate 40 is configured to fasten the on-board charger 10 and the liquid cooling plate 50.

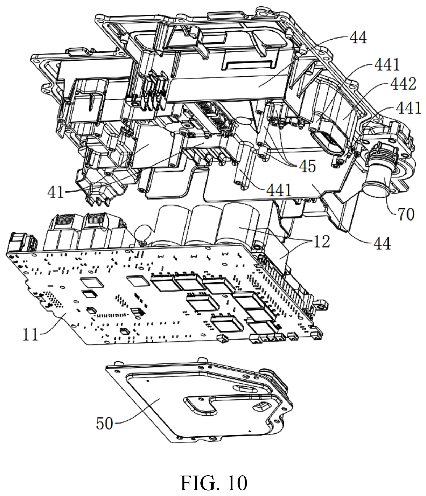

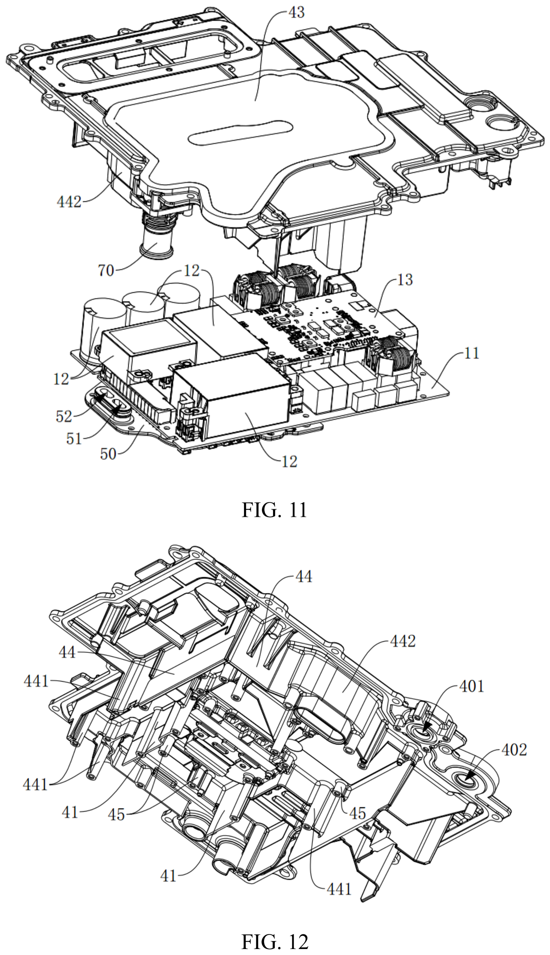

FIG. 9 is a diagram of a partial structure of the in-vehicle apparatus 100 according to an embodiment of this application, FIG. 10 is a diagram of an exploded structure of the in-vehicle apparatus 100 according to an embodiment of this application, FIG. 11 is a diagram of an exploded structure of the in-vehicle apparatus 100 according to an embodiment of this application, and FIG. 12 is a diagram of a partial structure of the in-vehicle apparatus 100 according to an embodiment of this application.

In an embodiment, the electrical accommodation groove 31 is further configured to accommodate a first circuit board 11, the first circuit board 11 is arranged between the liquid cooling plate 50 and the electrical cover plate 40, the electrical cover plate 40 is configured to fasten the first circuit board 11, and the first circuit board 11 is configured to fasten electrical components of the on-board charger 10.

In embodiments of this application, the all-in-one in-vehicle apparatus 100 is also referred to as an all-in-one in-vehicle power supply apparatus.

In this embodiment, the first circuit board 11 is configured to fasten the electrical components of the on-board charger 10, so that the in-vehicle apparatus 100 in this application has a function of supplying power to the power battery 201 and supplying power to another load of the electric vehicle 200 through the power battery 201. The first circuit board 11 is arranged between the liquid cooling plate 50 and the electrical cover plate 40, so that the liquid cooling plate 50 may dissipate heat for an electrical component fastened to one side of the first circuit board 11, and the cover plate internal flow channel may dissipate heat for an electrical component fastened to the other side of the first circuit board 11. In this way, the in-vehicle apparatus 100 can achieve good heat dissipation effect for the on-board charger 10, to ensure reliable operation of the on-board charger 10.

In an embodiment, the first circuit board 11 and the liquid cooling plate 50 are spaced from each other, and a plurality of power modules 14 in the electrical components of the on-board charger 10 are fastened between the first circuit board 11 and the liquid cooling plate 50. When flowing through the liquid cooling plate 50, the cooling water may dissipate heat for the plurality of power modules 14. The liquid cooling plate 50 and the electrical cover plate 40 jointly dissipate heat for the on-board charger 10, to ensure reliable operation of the on-board charger 10. In other words, in the height direction of the in-vehicle apparatus 100, the plurality of power modules 14 are fastened to a surface that is of the first circuit board 11 and that faces the liquid cooling plate 50, and an orthographic projection of the liquid cooling plate 50 covers the plurality of power modules 14.

In an embodiment, at least some of the power modules 14 are configured to form an alternating current conversion circuit of the on-board charger 10. The on-board charger 10 is configured to convert a high-voltage charging current from an alternating current into a direct current through the plurality of power modules 14, to charge the power battery 201. The power modules 14 are one of main heat sources of the on-board charger 10. The plurality of power modules 14 are spaced from each other in a plane direction of the first circuit board 11. Because the liquid cooling plate 50 and the first circuit board 11 are stacked, the liquid cooling plate 50 is closer to the plurality of power modules 14 in a thickness direction of the first circuit board 11. The orthographic projection of the liquid cooling plate 50 covers the plurality of power modules 14, so that the liquid cooling plate 50 may separately dissipate heat for the power modules 14, to ensure reliable operation of the on-board charger 10.

In embodiments of this application, a comparison between an orthographic projection of "A" in a direction and "B" may be understood as a comparison between an orthographic projection of "A" on "B" and an area of "B", or may be understood as a comparison between two orthographic projections that are of "A" and "B" and that are respectively formed on "C". "C" is a planar structure perpendicular to the direction. For example, in the height direction of the in-vehicle apparatus 100, "C" may be any one of the electrical cover plate 40, a bottom plate 32, a circuit board of the on-board charger 10, or a circuit board of the motor control unit 20.

In an embodiment, the liquid cooling plate 50 abuts against the power modules 14. In an embodiment, a thermally conductive material, for example, a thermally conductive adhesive, is included between the liquid cooling plate 50 and the power modules 14, so that the liquid cooling plate 50 is thermally connected to the power modules 14 through the thermally conductive material. The thermally conductive material may be further used to adapt to an assembly tolerance between the liquid cooling plate 50 and the power modules 14, to reduce internal stress of the in-vehicle apparatus 100 provided in this application.

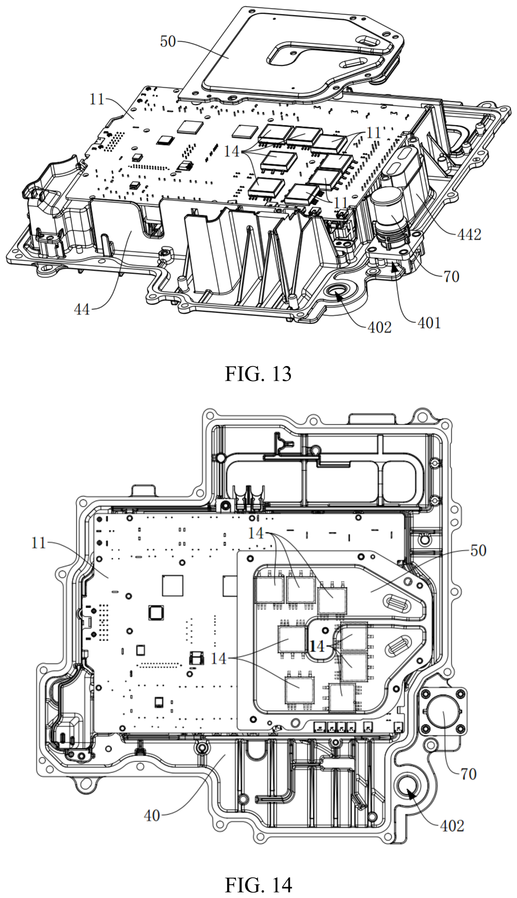

FIG. 13 is a diagram of an exploded structure of the in-vehicle apparatus 100 according to an embodiment of this application, and FIG. 14 is a diagram of a plane structure of the in-vehicle apparatus 100 according to an embodiment of this application.

In an embodiment, a side that is of the first circuit board 11 and that faces the liquid cooling plate 50 is configured to fasten the plurality of power modules 14 in the electrical components of the on-board charger 10, a projection of the liquid cooling plate 50 on the first circuit board 11 covers the plurality of power modules 14, and an outlet of the liquid cooling plate 50 is configured to deliver the cooling water to the cover plate internal flow channel.

In this embodiment, the liquid cooling plate 50 is configured to dissipate heat for the plurality of power modules 14. After the cooling water in the liquid cooling plate 50 dissipates heat for the plurality of power modules 14, the cooling water further flows into the cover plate internal flow channel, so that the electrical cover plate 40 can input the cooling water and receive the cooling water via the cover plate internal flow channel, and the cooling water can dissipate heat in the liquid cooling plate 50 in a circulating manner, to further ensure reliable operation of the plurality of power modules 14 of the on-board charger 10.

In an embodiment, a side that is of the first circuit board 11 and that faces the electrical cover plate 40 is configured to fasten a capacitor component and an inductor component 12 of the on-board charger 10, and a projection of the cover plate internal flow channel on the first circuit board 11 covers at least a part of the capacitor component and the inductor component 12.

In this embodiment, the cover plate internal flow channel is configured to dissipate heat for the capacitor component and the inductor component 12. The electrical cover plate 40 and the liquid cooling plate 50 jointly dissipate heat for the on-board charger 10, to ensure reliable operation of the on-board charger 10.

In an embodiment, a side that is of the electrical cover plate 40 and that faces the first circuit board 11 includes a plurality of shielding protrusions 41, and the plurality of shielding protrusions 41 are separately configured to be embedded in gaps between other electrical components of the on-board charger 10.

In this embodiment, the first circuit board 11 and the electrical cover plate 40 are spaced from each other, and the capacitor component and the inductor component 12 in the electrical components of the on-board charger 10 are fastened between the first circuit board 11 and the electrical cover plate 40. The cooling water may dissipate heat for the capacitor component and the inductor component 12 when flowing through the cover plate internal flow channel of the electrical cover plate 40. The plurality of shielding protrusions 41 on the side that is of the electrical cover plate 40 and that faces the first circuit board 11 are configured to implement electromagnetic shielding inside the capacitor component, inside the inductor component, and between the capacitor component and the inductor component 12. The electrical cover plate 40 can implement heat dissipation and shielding functions for the on-board charger 10.

In an embodiment, some capacitor components or inductor components in a plurality of capacitor components or inductor components 12 are fastened to the electrical cover plate 40. In the height direction of the in-vehicle apparatus 100, some capacitor components and inductor components are fastened to the side that is of the electrical cover plate 40 and that faces the first circuit board 11. In other words, the first circuit board 11, the plurality of capacitor components and inductor components 12, and the electrical cover plate 40 are sequentially stacked. A coverage area of the cover plate internal flow channel in the height direction of the in-vehicle apparatus 100 covers orthographic projections of the plurality of capacitor components and inductor components 12.

In an embodiment, the electrical cover plate 40 includes an annular baffle 44 and a plurality of circuit board support posts 45. The annular baffle 44 and the plurality of circuit board support posts 45 extend from the electrical cover plate 40 toward a groove bottom of the electrical accommodation groove 31 in the height direction of the in-vehicle apparatus 100. An extension length of each of the plurality of circuit board support posts 45 is less than an extension length of the annular baffle 44, and the annular baffle 44 is configured to surround peripheries of the plurality of circuit board support posts 45. The plurality of circuit board support posts 45 are configured to fasten the first circuit board 11 of the on-board charger 10, and the first circuit board 11 is configured to fasten the electrical components of the on-board charger 10. The annular baffle 44 is configured to fasten the liquid cooling plate 50. A length of the circuit board support post 45 is shorter than that of a columnar reinforcing rib 441, and the on-board charger 10 is closer to the electrical cover plate 40 than the liquid cooling plate 50. Therefore, the liquid cooling plate 50, the on-board charger 10, and the electrical cover plate 40 are sequentially stacked in the height direction of the in-vehicle apparatus 100, and the on-board charger 10 is fastened between the liquid cooling plate 50 and the electrical cover plate 40.

In an embodiment, the annular baffle 44 includes a plurality of columnar reinforcing ribs 441, and the plurality of columnar reinforcing ribs 441 are spaced and arranged in the annular baffle 44 along an extension path of the annular baffle 44 around the plurality of circuit board support posts 45. The plurality of columnar reinforcing ribs 441 are configured to improve structural stability of the annular baffle 44. The annular baffle 44 further fastens the liquid cooling plate 50 through the plurality of columnar reinforcing ribs 441. The electrical components of the on-board charger 10 and the first circuit board 11 are accommodated in the annular baffle 44, and the annular baffle 44 is configured to protect the on-board charger 10. The plurality of columnar reinforcing ribs 441 of the annular baffle 44 include one connection post 442. A cross-sectional size of the connection post 442 is greater than a cross-sectional size of the remaining columnar reinforcing ribs 441. The electrical cover plate 40 is configured to connect to the liquid cooling plate 50 via the connection post 442.

In an embodiment, at least one capacitor component and at least one inductor component in the plurality of capacitor components and inductor components 12 are configured to form a direct current conversion circuit of the on-board charger 10. The on-board charger 10 is configured to: adjust a voltage of a current through some capacitor components and inductor components, and then output the current to an electrical component in the vehicle. The capacitor components and the inductor components 12 are one of main heat sources of the on-board charger 10. The plurality of capacitor components and inductor components 12 are spaced from each other in the plane direction of the first circuit board 11. Because the cover plate internal flow channel and the plurality of capacitor components and inductor components 12 are stacked in the thickness direction of the first circuit board 11, when the cooling water flows into the cover plate internal flow channel, the cooling water may separately dissipate heat for the plurality of capacitor components and inductor components 12, to ensure reliable operation of the on-board charger 10.

In an embodiment, the on-board charger 10 includes a small circuit board 13. An area of the small circuit board 13 is less than an area of the first circuit board 11. The small circuit board 13 is configured to fasten some electrical components of the on-board charger 10. The first circuit board 11, the small circuit board 13, and the electrical cover plate 40 are sequentially stacked in the height direction of the in-vehicle apparatus 100. The some electrical components of the on-board charger 10 are fastened to a surface that is of the small circuit board 13 and that faces the electrical cover plate 40. A coverage area of the cover plate internal flow channel covers orthographic projections of the some electrical components of the on-board charger 10.

In an embodiment, an electrical component that is of the on-board charger 10 and that is fastened to the small circuit board 13 is configured to form a direct current conversion circuit of the on-board charger 10. In an embodiment, the small circuit board 13 is electrically connected to the first circuit board 11 through one capacitor component and one inductor component 12. The small circuit board 13 is configured to fasten an electrical component of a secondary-side circuit in the direct current conversion circuit, and the first circuit board 11 is configured to fasten an electrical component of a primary-side circuit in the direct current conversion circuit. The primary-side circuit is configured to receive a high-voltage direct current output by the power battery 201. After power conversion is performed by the capacitor component and the inductor component 12, and the secondary-side circuit on the high-voltage direct current, the on-board charger 10 outputs a low-voltage direct current through the secondary-side circuit to supply power to the second-type load 220 of the vehicle.

In other words, the on-board charger 10 is configured to carry the electrical components of the secondary-side circuit of the on-board charger 10 through the small circuit board 13. The electrical component of the secondary-side circuit is one of heat sources of the on-board charger 10. Electrical components of the secondary-side circuit are spaced from each other in the plane direction of the first circuit board 11. The electrical cover plate 40 and some electrical components of the secondary-side circuit are stacked in the height direction of the in-vehicle apparatus 100, the cover plate internal flow channel is close to the some electrical components of the secondary-side circuit in the thickness direction of the first circuit board 11, and a coverage area of the cover plate internal flow channel covers orthographic projections of the some electrical components of the secondary-side circuit. In this way, heat can be dissipated for the some electrical components of the secondary-side circuit, to ensure reliable operation of the on-board charger 10.

In an embodiment, the on-board charger 10 includes a small circuit board 13, and a plurality of capacitor components and inductor components 12. In the plane direction of the in-vehicle apparatus 100, the small circuit board 13 is adjacently arranged with the plurality of capacitor components and inductor components 12. In the height direction of the in-vehicle apparatus 100, the small circuit board 13, and the plurality of capacitor components and inductor components 12 are arranged between the first circuit board 11 and the electrical cover plate 40. Areas of the plurality of capacitor components and inductor components 12 in the plane direction of the in-vehicle apparatus 100 are smaller than the area of the first circuit board 11, and sizes of the plurality of capacitor components and inductor components 12 in the height direction of the in-vehicle apparatus 100 are large. When the first circuit board 11, the plurality of capacitor components and inductor components 12, and the electrical cover plate 40 are arranged in the height direction of the in-vehicle apparatus 100, a part of a region spaced between the first circuit board 11 and the electrical cover plate 40 is formed on sides of the plurality of capacitor components and inductor components 12. Some electrical components of the on-board charger 10 are mounted on the small circuit board 13, so that a space region on the sides of the plurality of capacitor components and inductor components 12 can be properly used. Therefore, an overall area of the on-board charger 10 can be reduced, and it is ensured that the cover plate internal flow channel reliably dissipates heat for the plurality of capacitor components and inductor components 12, and the electrical components of the secondary-side circuit.

In an embodiment, the area of the small circuit board 13 is less than half of the area of the first circuit board 11. The area of the small circuit board 13 is controlled, to control a total area of the small circuit board 13 and the plurality of capacitor components and inductor components 12 that are adjacently arranged to be less than or equal to the area of the first circuit board 11, to avoid an increase in an overall area of the in-vehicle apparatus 100 in this application caused by an excessively large area of the small circuit board 13.

In an embodiment, the small circuit board 13, the plurality of capacitor components and inductor components 12, and the connection post 442 are sequentially arranged in a plane direction of the in-vehicle apparatus 100. For ease of description, in subsequent embodiments of this application, an arrangement direction of the small circuit board 13, and the plurality of capacitor components and inductor components 12 is defined as a first direction 001. The first direction 001 is a plane direction of the in-vehicle apparatus 100.

The electrical cover plate 40 is connected to the liquid cooling plate 50 via the connection post 442. A portion of the cooling water that enters the cover plate internal flow channel from the cover plate water channel inlet 401 flows into the liquid cooling plate 50 via the connection post 442, and the other portion of the cooling water flows through the cover plate internal flow channel, and sequentially passes through orthographic projection regions of the plurality of capacitor components and inductor components 12. A temperature of the cooling water flowing through the cover plate water channel inlet 401 is low, and the connection post 442 is disposed closer to a side of the cover plate water channel inlet 401 than the plurality of capacitor components and inductor components 12, so that the temperature of the cooling water flowing into the liquid cooling plate 50 is low, and a temperature of the cooling water flowing into the plurality of capacitor components and inductor components 12 is also low. This helps balance heat dissipation effect between the electrical components of the on-board charger 10, reduces a temperature difference between the electrical components, and ensures temperature balance between the electrical components of the on-board charger 10.

The plurality of capacitor components and inductor components 12 generate more heat than the electrical components of the secondary-side circuit during operating. Therefore, disposing the plurality of capacitor components and inductor components 12 closer to a side of the cover plate water channel inlet 401 than the electrical components of the secondary-side circuit allows the cooling water with the low temperature to first exchange heat with the plurality of capacitor components and inductor components 12, and then exchange heat with the electrical components of the secondary-side circuit. This helps balance heat dissipation effect of the electrical cover plate 40 on the plurality of capacitor components and inductor components 12, and the electrical components of the secondary-side circuit, reduces a temperature difference between the plurality of capacitor components and inductor components 12 and the electrical components of the secondary-side circuit, and further ensures temperature balance between components of the on-board charger 10.

In an embodiment, in the height direction of the in-vehicle apparatus 100, the orthographic projections of the plurality of capacitor components and inductor components 12 partially overlap orthographic projections of the plurality of power modules 14.

In this embodiment, in the thickness direction of the first circuit board 11, the plurality of capacitor components and inductor components 12, and the plurality of power modules 14 are respectively arranged on two sides of the first circuit board 11. In addition, the orthographic projections of the power modules 14 on the first circuit board 11 and the orthographic projections of the plurality of capacitor components and inductor components 12 on the first circuit board 11 overlap. The power modules 14, and the plurality of capacitor components and inductor components 12 generate large amounts of heat, the orthographic projections of the power modules 14 are covered by the liquid cooling plate 50, and after two groups of electrical components are stacked in the height direction of the in-vehicle apparatus 100, a structure in which the orthographic projections of the plurality of capacitor components and inductor components 12 partially overlap the liquid cooling plate 50 is formed. Therefore, the liquid cooling plate 50 can dissipate heat for the plurality of capacitor components and inductor components 12, thereby improving overall heat dissipation effect for the on-board charger 10.

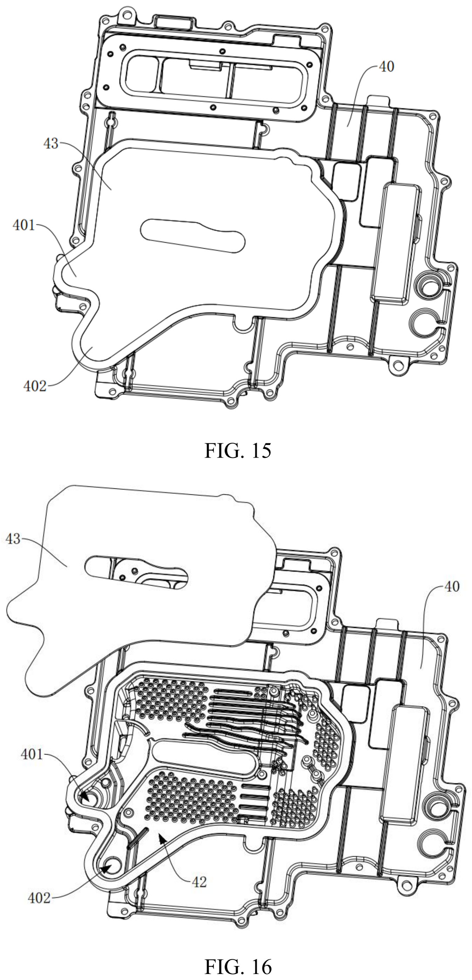

FIG. 15 is a diagram of a partial structure of the in-vehicle apparatus 100 according to an embodiment of this application, and FIG. 16 is a diagram of an exploded structure of the in-vehicle apparatus 100 according to an embodiment of this application.

In an embodiment, the electrical cover plate 40 includes a cooling groove 42 and a cooling cover plate 43, the cooling groove 42 is distributed on a side that is of the electrical cover plate 40 and that is away from the electrical accommodation groove 31, and the cooling cover plate 43 is configured to enclose the cooling groove 42 to form the cover plate internal flow channel. A groove bottom of the cooling groove 42 includes a third through hole 423, a fourth through hole 424, and a first separation protrusion 425. The third through hole 423 is configured to communicate with the cover plate water channel inlet 401, the fourth through hole 424 is configured to communicate with the cover plate water channel outlet 402, and the first separation protrusion 425 is configured to separate the third through hole 423 from the fourth through hole 424 to form a U-shaped flow channel.

In this embodiment, a direction of a groove opening of the cooling groove 42 of the electrical cover plate 40 is the same as a direction of a groove opening of the electrical accommodation groove 31, and the cooling cover plate 43 covers the cooling groove 42 to form the cover plate internal flow channel. When accidental leakage occurs in the cover plate internal flow channel, the cooling water leaks in a direction away from the electrical accommodation groove 31, so that the electrical components in the electrical accommodation groove 31 can be protected. The first separation protrusion 425 is configured to form the U-shaped flow channel in the cover plate internal flow channel, to extend a flow path of the cooling water from the third through hole 423 to the fourth through hole 424, that is, extend a flow path of the cooling water in the cover plate internal flow channel. In this way, the cooling water in the cover plate internal flow channel exchanges sufficient heat with the on-board charger 10, to improve heat dissipation effect.

In another description manner, the groove bottom of the cooling groove 42 includes two through holes, one of the through holes is configured to communicate with the cover plate water channel inlet 401, and the other through hole is configured to communicate with the internal water inlet channel. One through hole is the third through hole 423 of the electrical cover plate 40, and the other through hole is the fourth through hole 424.

In the height direction of the in-vehicle apparatus 100, both the third through hole 423 and the fourth through hole 424 of the electrical cover plate 40 face the integrated housing 30. In other words, the cover plate water channel inlet 401 faces the integrated housing 30. In this way, the water cooling system of the electric vehicle 200 communicates with the cover plate water channel inlet 401 from a side that is of the electrical cover plate 40 and that faces the integrated housing 30. Because the electrical cover plate 40 and the bottom plate 32 form a top surface and a bottom surface of the in-vehicle apparatus 100 in this application in a high-low direction, disposing an opening of the cover plate water channel inlet 401 to face the bottom surface can control a mounting height of the in-vehicle apparatus 100 in this application. In this application, a connection structure of the cover plate water channel inlet 401 does not need to be disposed on the top surface of the in-vehicle apparatus 100, that is, a side that is of the electrical cover plate 40 and that is away from the bottom plate 32. Therefore, an outline structure of the side that is of the electrical cover plate 40 and that is away from the integrated housing 30 is simplified, so that an overall height of the in-vehicle apparatus 100 can be reduced.

Because an area of a surface that is of the electrical cover plate 40 and that faces the bottom plate 32 is large, disposing the fourth through hole 424 to face the integrated housing 30 facilitates communication between the cover plate internal flow channel and the internal water inlet channel and ensures sealing effect.

In embodiments of this application, the cover plate internal flow channel includes the cooling groove 42 and the cooling cover plate 43 of the electrical cover plate 40. In other words, a structure enclosed by the cooling groove 42 and the cooling cover plate 43 is a structure of the internal flow channel. Therefore, the cover plate internal flow channel is not separately shown by a reference numeral.

In an embodiment, the cooling groove 42 of the electrical cover plate 40 may be formed through processing, and the cooling cover plate 43 may also be obtained through mechanical processing, thereby reducing overall processing costs of the electrical cover plate 40. In an embodiment, the cooling groove 42 is formed through die casting.

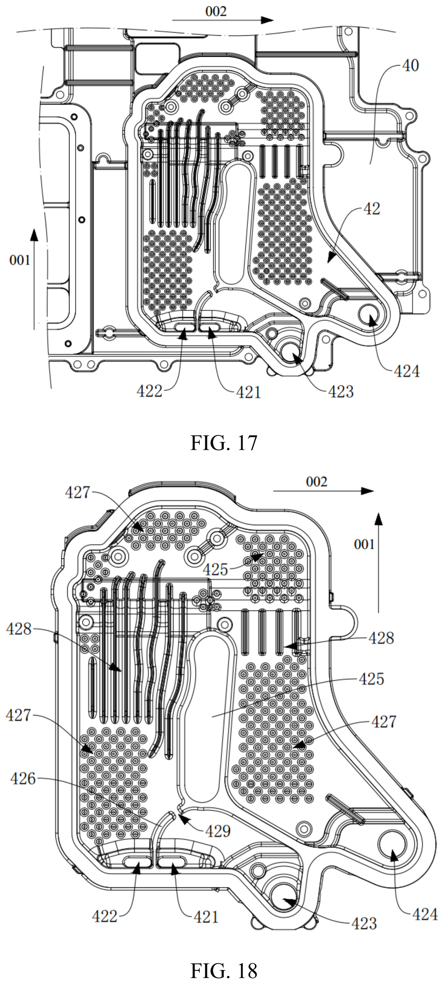

FIG. 17 is a diagram of a partial structure of the in-vehicle apparatus 100 according to an embodiment of this application, and FIG. 18 is a diagram of a partial structure of the in-vehicle apparatus 100 according to an embodiment of this application.

In an embodiment, the groove bottom of the cooling groove 42 includes a first through hole 421, a second through hole 422, and a second separation protrusion 426, the first through hole 421 and the second through hole 422 separately penetrate the groove bottom of the cooling groove 42, the first through hole 421 is configured to communicate with the inlet 51 of the liquid cooling plate 50, the second through hole 422 is configured to communicate with the outlet 52 of the liquid cooling plate 50, the second separation protrusion 426 is configured to separate the first through hole 421 from the second through hole 422, the third through hole 423 and the first through hole 421 are arranged between the first separation protrusion 425 and the second separation protrusion 426, the first through hole 421 and the third through hole 423 are arranged on one side of the second separation protrusion 426, and the second through hole 422 is arranged on the other side of the second separation protrusion 426.

In this embodiment, the cooling groove 42 communicates with the liquid cooling plate 50 via the first through hole 421 and the second through hole 422, to circulate the cooling water to the liquid cooling plate 50. The third through hole 423 and the first through hole 421 are arranged between the first separation protrusion 425 and the second separation protrusion 426, and the second separation protrusion 426 is configured to separate the first through hole 421 from the second through hole 422, so that the cooling water that enters the cover plate internal flow channel from the cover plate water channel inlet 401 via the third through hole 423 first flows into the liquid cooling plate 50 from the first through hole 421, then flows back to the cover plate internal flow channel via the second through hole 422, and then flows into the housing water channel inlet 301 from the cover plate water channel outlet 402 via the fourth through hole 424. Such an arrangement manner can ensure that a temperature of the cooling water flowing into the liquid cooling plate 50 is low, and improve heat dissipation effect of the liquid cooling plate 50 on the plurality of power modules 14.

In an embodiment, the second through hole 422, the first through hole 421, the third through hole 423, and the fourth through hole 424 are sequentially spaced from each other in a second direction 002. Therefore, the first through hole 421 is closer to the cover plate water channel inlet 401 of the in-vehicle apparatus 100 in the second direction 002 than the second through hole 422. After entering the cover plate internal flow channel from the third through hole 423, the cooling water may first enter the inlet 51 of the liquid cooling plate 50 via the first through hole 421. In this case, a temperature of the cooling water is low, and heat dissipation effect of the liquid cooling plate 50 can be improved. With reference to an arrangement of the flow path of the cover plate internal flow channel, the cooling water flowing out of the second through hole 422 flows into the internal water inlet channel via the fourth through hole 424, and the portion of the cooling water may flow through the orthographic projection regions of the plurality of capacitor components and inductor components 12 on the electrical cover plate 40, to ensure heat dissipation effect of the cover plate internal flow channel on the on-board charger 10.

In an embodiment, the on-board charger 10, the first through hole 421, the second through hole 422, and the third through hole 423 are sequentially spaced from each other in the first direction 001. In other words, the first through hole 421 and the second through hole 422 are arranged between the on-board charger 10 and the third through hole 423 in the first direction 001. Because both the first through hole 421 and the second through hole 422 are located in a projection region of the connection post 442, that is, the connection post 442 is closer to the cover plate water channel inlet 401 of the electrical cover plate 40 than the on-board charger 10, after the cooling water enters the cover plate internal flow channel from the cover plate water channel inlet 401, the cooling water may enter the liquid cooling plate 50 via the first through hole 421 on the connection post 442, to cool the on-board charger 10. In this case, a temperature of the cooling water is low, and heat dissipation effect of the liquid cooling plate 50 can be improved.

In another description manner, a section of the first separation protrusion 425, the second separation protrusion 426, and a section of a groove wall of the cooling groove 42 form a fence at the groove bottom of the cooling groove 42, the fence is configured to seal the first through hole 421 and the third through hole 423, and the second through hole 422 and the fourth through hole 424 are located outside the fence.

In other words, a side that is of the cooling groove 42 and that is close to a groove wall of the third through hole 423 includes the fence. The fence surrounds the first through hole 421 and the third through hole 423. After entering the cooling groove 42 from the third through hole 423, the cooling water needs to enter the liquid cooling plate 50 via the first through hole 421. After dissipating heat for the power modules 14, the cooling water flows back from the second through hole 422 to a region that is of the cooling groove 42 and that is located outside the fence. After flowing around the other section of the first separation protrusion 425, the cooling water flows into the internal water inlet channel via the fourth through hole 424.

Therefore, the fence can control a flow path of the cooling water in the electrical cover plate 40 by separating the third through hole 423 from the fourth through hole 424 and separating the first through hole 421 from the second through hole 422. The third through hole 423 communicates with the first through hole 421 via the fence, that is, the third through hole 423 of the electrical cover plate 40 communicates with the inlet of the liquid cooling plate 50 via the fence. The outlet of the liquid cooling plate 50 communicates with the fourth through hole 424 through a part that is of the cover plate internal flow channel and that is located outside the fence.

The fence limits a flow direction of the cooling water in the cover plate internal flow channel, and the cooling water with a low temperature that enters the cooling groove 42 from the third through hole 423 cannot directly enter the internal water inlet channel via the fourth through hole 424. Therefore, a large portion of the cooling water with the low temperature flows to the liquid cooling plate 50 in the fence, to ensure that the power modules 14 are well cooled.

Outside the fence, by designing the internal flow channel of the electrical cover plate 40, the cooling water flowing out of the second through hole 422 may be controlled to sequentially flow through the capacitor components and the inductor components 12, and the electrical components of the secondary-side circuit, and after dissipating sufficient heat for the electrical components of the on-board charger 10, the cooling water flows into the internal water inlet channel via the fourth through hole 424.

In this case, the other section of the first separation protrusion 425 forms a flow-guiding structure at the groove bottom of the cooling groove 42, and the flow-guiding structure includes two opposite ends in a direction perpendicular to an arrangement direction of the second through hole 422 and the fourth through hole 424. One end of the flow-guiding structure is configured to connect to a side wall that is of the fence and that is away from the first through hole 421, and the other end of the flow-guiding structure is configured to extend in a direction away from the fence. In the diagram shown in the figure, the second through hole 422 and the fourth through hole 424 are spaced from each other in the second direction 002, and the flow-guiding structure is configured to extend in the first direction 001, to prevent the cooling water flowing out of the second through hole 422 from directly flowing into the fourth through hole 424 in the second direction 002.

In this embodiment, the cooling water flowing out of the liquid cooling plate 50 needs to first flow in the first direction 001 toward the small circuit board 13, then flows to the other side of the flow-guiding structure in the second direction 002, then flows toward the fence in the first direction 001, and finally flows into the internal water inlet channel via the fourth through hole 424. The fence and the flow-guiding structure are configured to guide a flow path of the cooling water in the cooling groove 42, so that the cooling water can sequentially flow in the part that is of the cover plate internal flow channel and that is located outside the fence, and after fully dissipating heat for the plurality of capacitor components and inductor components 12, and the electrical components of the secondary-side circuit, the cooling water flows into the bottom housing internal flow channel via the fourth through hole 424, to ensure heat dissipation effect of the cover plate internal flow channel on the plurality of capacitor components and inductor components 12, and the electrical components of the secondary-side circuit.

In an embodiment, the groove bottom of the cooling groove 42 further includes a plurality of heat dissipation fins 427 and a plurality of flow-guiding fins 428. The plurality of heat dissipation fins 427 are distributed on two sides of the first separation protrusion 425, the plurality of flow-guiding fins 428 are distributed on the two sides of the first separation protrusion 425, and at least one of quantities, shapes, or arrangement manners of at least one of the flow-guiding fins 428 or the heat dissipation fins 427 on the two sides of the first separation protrusion 425 is different.

In this embodiment, the plurality of heat dissipation fins 427 are configured to slow down a flow rate of the cooling water in the cover plate internal flow channel, to improve heat exchange effect when the cooling water flows through the plurality of heat dissipation fins 427, and the plurality of flow-guiding fins 428 are configured to guide the cooling water to flow along a flow path in the cover plate internal flow channel. The plurality of heat dissipation fins 427 and the plurality of flow-guiding fins 428 are alternately arranged in the cover plate internal flow channel, so that heat dissipation regions of different quantities, different sizes, and different regions may be formed in the cover plate internal flow channel, and each heat dissipation region is individually matched to a quantity, shapes, and locations of the electrical components of the on-board charger 10.

In another description manner, the groove bottom of the cooling groove 42 includes the plurality of heat dissipation fins 427 and the plurality of flow-guiding fins 428. The plurality of heat dissipation fins 427 and the plurality of flow-guiding fins 428 are located in the part that is of the cover plate internal flow channel and that is located outside the fence, and are spaced from each other along a flow path from the second through hole 422 to the fourth through hole 424.

In an embodiment, the plurality of heat dissipation fins 427 are configured to disturb a flow direction of the cooling water to balance a temperature of the cooling water. In an embodiment, each heat dissipation fin 427 include a plurality of columnar protrusions, and the plurality of columnar protrusions are roughly arranged in an array in a plane direction of the electrical cover plate 40. When the cooling water flows through the plurality of columnar protrusions, a large amount of turbulence is generated, to improve heat exchange between the cooling water and balance a temperature of the cooling water flowing through the heat dissipation fins 427.

The plurality of flow-guiding fins 428 are configured to guide the cooling water to flow along the flow path from the second through hole 422 to the fourth through hole 424. In an embodiment, each flow-guiding fin 428 includes a plurality of strip-shaped protruding ribs, an extension direction of each strip-shaped protruding rib is approximately parallel to the flow path from the second through hole 422 to the fourth through hole 424, and the plurality of strip-shaped protruding ribs are spaced from each other in a direction perpendicular to the flow path from the second through hole 422 to the fourth through hole 424. When the cooling water flows through the plurality of strip-shaped protruding ribs, a flow resistance is small, and the cooling water can flow through the flow-guiding fins 428 quickly.

The plurality of heat dissipation fins 427 and the plurality of flow-guiding fins 428 are spaced from each other along the flow path from the second through hole 422 to the fourth through hole 424, to balance a temperature difference and a flow rate of the cooling water, and ensure heat dissipation effect of the cooling water on the plurality of capacitor components and inductor components 12, and the electrical components of the secondary-side circuit.

In an embodiment, in the height direction of the in-vehicle apparatus 100, orthographic projections of each capacitor component and each inductor component 12 overlap at least one heat dissipation fin 427. A flow resistance of the heat dissipation fin 427 is large, and a flow rate of the cooling water in the heat dissipation fin 427 is low. The cooling water may sufficiently exchange sufficient heat with the capacitor components and the inductor components 12 in the heat dissipation fins 427, to improve heat dissipation effect of the cooling water on the capacitor components and the inductor components 12.

In an embodiment, in the height direction of the in-vehicle apparatus 100, orthographic projections of some electrical components of the secondary-side circuit overlap at least one heat dissipation fin 427. Similar to the foregoing reason, the cooling water may exchange sufficient heat with a magnetic component 15 in the heat dissipation fins 427, to improve heat dissipation effect of the cooling water on the magnetic component 15.

In an embodiment, in the arrangement direction of the second through hole 422 and the fourth through hole 424, each of two sides of the flow-guiding structure includes at least one flow-guiding fin 428. In other words, the at least one flow-guiding fin 428 is included on each of the two sides of the flow-guiding structure in the second direction 002. In this way, an overall flow rate of the cooling water in the electrical cover plate 40 can be ensured.

In an embodiment, at least one heat dissipation fin 427 is included on each of two sides of the flow-guiding structure in the second direction 002. Because there are orthographic projections of the capacitor component and the inductor component 12 on each of two sides of the flow-guiding structure in the second direction 002, disposing the orthographic projections of the capacitor components and the inductor components 12 corresponding to the heat dissipation fins 427 to cooperate with each other can improve heat dissipation effect of the electrical cover plate 40 on the on-board charger 10.

In an embodiment, a section of the first separation protrusion 425 is spaced from the second separation protrusion 426, so that the fence forms a notch 429. In the arrangement direction of the second through hole 422 and the fourth through hole 424, the notch 429 is located on a side that is of the flow-guiding structure and that is close to the second through hole 422. In other words, the notch 429 is located between the second through hole 422 and the flow-guiding structure in the second direction 002. The notch 429 of the fence is configured for communication of the fence and the part that is of the cover plate internal flow channel and that is located outside the fence. Therefore, a portion of the cooling water that enters the fence from the third through hole 423 may flow, via the notch 429, into the part that is of the cover plate internal flow channel and that is located outside the fence. A temperature of the portion of cooling water is low. After the portion of cooling water converges with the cooling water flowing out of the liquid cooling plate 50, heat dissipation effect of the cover plate internal flow channel on the plurality of capacitor components and inductor components 12, and the electrical components of the secondary-side circuit can be improved, and then the cooling water flows into the bottom housing internal flow channel through the flow path from the second through hole 422 to the fourth through hole 424.

In an embodiment, along the flow path from the second through hole 422 to the fourth through hole 424, the notch 429, some heat dissipation fins 427, and some flow-guiding fins 428 are sequentially arranged. The cooling water flowing out of the notch 429 may first pass through the some heat dissipation fins 427 and be fully mixed with the cooling water flowing out of the liquid cooling plate 50, to reduce an overall temperature of the cooling water flowing to the capacitor components and the inductor components 12, and then flows into the flow-guiding fins 428 to dissipate heat for the capacitor components and the inductor components 12, thereby improving heat dissipation effect of the cover plate internal flow channel on the plurality of capacitor components and inductor components 12, and the electrical components of the secondary-side circuit.

In an embodiment, an opening area of the notch 429 is less than a hole area of the first through hole 421. The limitation on the opening area of the notch 429 can limit a flow of cooling water flowing out of the fence from the notch 429. Most of the cooling water flowing into the fence from the third through hole 423 flows into the liquid cooling plate 50, to ensure cooling effect of the liquid cooling plate 50 on the power modules 14. A small portion of the cooling water flows from the notch 429 into the part that is of the cover plate internal flow channel and that is located outside the fence and converges with the cooling water flowing out of the liquid cooling plate 50, to balance temperatures of the cooling water in the cover plate internal flow channel and the liquid cooling plate 50, and improve heat dissipation effect on the on-board charger 10.

In an embodiment, the notch 429, the first through hole 421, and the third through hole 423 are sequentially spaced from each other in the second direction 002. In an embodiment, the notch 429, the first through hole 421, and the third through hole 423 are sequentially spaced from each other in the first direction 001. In both the foregoing two embodiments, the first through hole 421 is closer to the third through hole 423 than the notch 429, and the cooling water entering the fence from the third through hole 423 first enters the liquid cooling plate 50 via the first through hole 421, to preferentially ensure heat dissipation effect of the liquid cooling plate 50, and balance heat dissipation effect of the cover plate internal flow channel and heat dissipation effect of the liquid cooling plate 50.

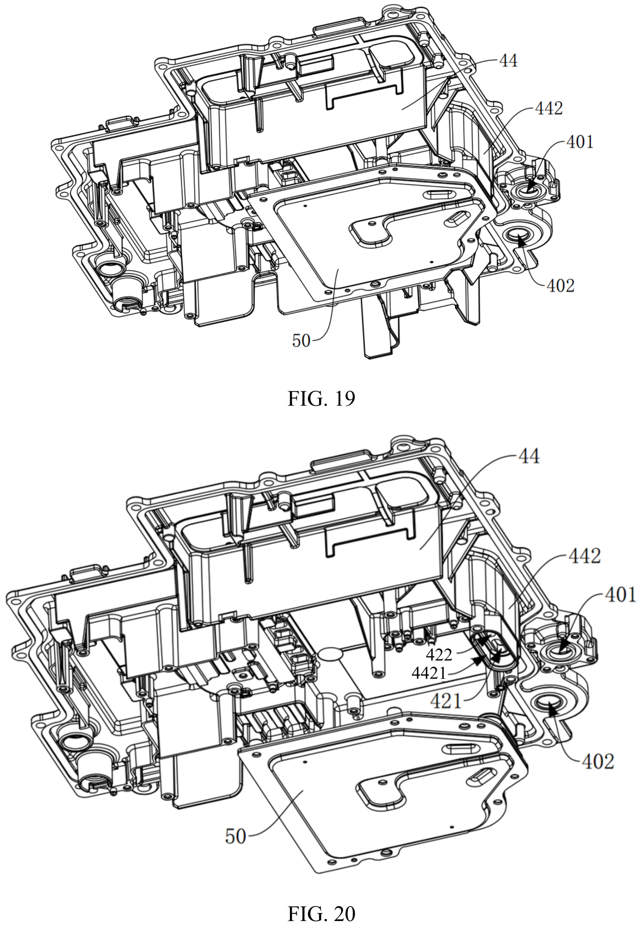

FIG. 19 is a diagram of a partial structure of the in-vehicle apparatus 100 according to an embodiment of this application, and FIG. 20 is a diagram of an exploded structure of the in-vehicle apparatus 100 according to an embodiment of this application

In an embodiment, the electrical cover plate 40 includes one connection post 442, the connection post 442 extends toward the liquid cooling plate 50, a surface that is of the connection post 442 and that faces the liquid cooling plate 50 includes a groove 4421, the groove 4421 is configured to accommodate a heat dissipation panel water nozzle 53 of the liquid cooling plate 50, the first through hole 421 penetrates the groove bottom of the cooling groove 42 and a groove bottom of the groove 4421 and is connected to the inlet 51 of the liquid cooling plate 50, and the second through hole 422 penetrates the groove bottom of the cooling groove 42 and the groove bottom of the groove 4421 and is connected to the outlet 52 of the liquid cooling plate 50.

In this embodiment, the liquid cooling plate 50 and the electrical cover plate 40 are spaced from each other, and the electrical cover plate 40 extends toward the liquid cooling plate 50 through the connection post 442 at the groove bottom of the cooling groove 42, to fasten and communicate with the heat dissipation panel water nozzle 53 of the liquid cooling plate 50. The groove 4421 on the surface that is of the connection post 442 and that faces the liquid cooling plate 50 is configured to increase a contact area between the connection post 442 and the heat dissipation panel water nozzle 53, to ensure a reliable connection and facilitate sealing, thereby ensuring that the inlet 51 and the outlet 52 of the liquid cooling plate 50 are reliably connected to the first through hole 421 and the second through hole 422 respectively.

In an embodiment, the electrical cover plate 40 accommodates the heat dissipation panel water nozzle 53 through a structure of the groove 4421, and forms a sealing fit with an outer wall of the heat dissipation panel water nozzle 53 through a groove wall of the groove 4421, to seal and connect the heat dissipation panel water nozzle 53.

Therefore, one end of an internal flow channel of the liquid cooling plate 50 communicates with the first through hole 421 of the connection post 442 via the inlet 51 of the liquid cooling plate 50, and the cooling water flowing into the first through hole 421 may enter the internal flow channel of the liquid cooling plate 50 to dissipate heat for the plurality of power modules 14. The other end of the internal flow channel of the liquid cooling plate 50 communicates with the second through hole 422 of the connection post 442 via the outlet 52 of the liquid cooling plate 50. After heat dissipation is completed, the cooling water in the liquid cooling plate 50 flows back to the cooling groove 42, and flows into the internal water inlet channel and the water cooling radiator 60 via the fourth through hole 424.

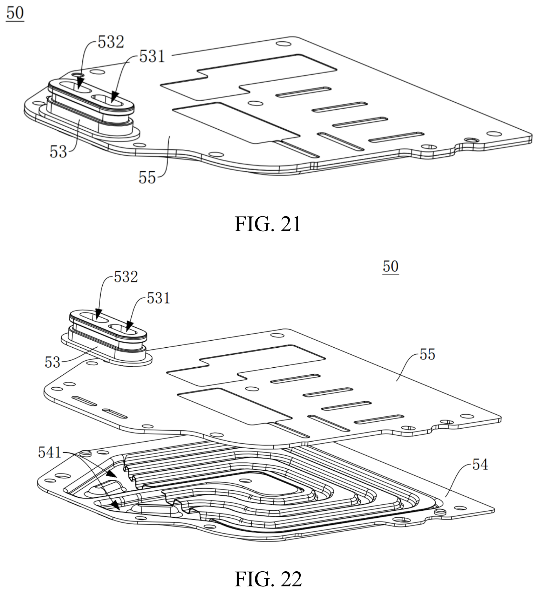

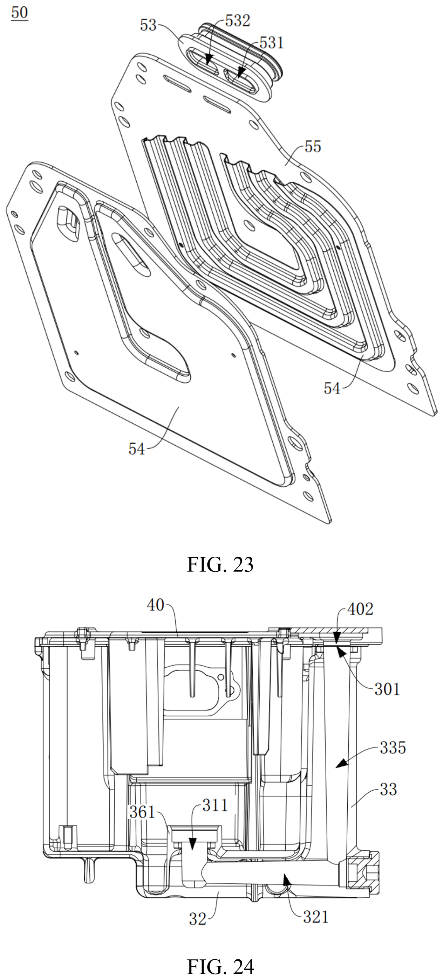

FIG. 21 is a diagram of a partial structure of the in-vehicle apparatus 100 according to an embodiment of this application, FIG. 22 is a diagram of an exploded structure of the in-vehicle apparatus 100 according to an embodiment of this application, and FIG. 23 is a diagram of an exploded structure of the in-vehicle apparatus 100 according to an embodiment of this application.

In an embodiment, the heat dissipation panel water nozzle 53 is located on a side that is of the liquid cooling plate 50 and that faces the electrical cover plate 40, the heat dissipation panel water nozzle 53 includes a first communication water channel 531 and a second communication water channel 532, the first communication water channel 531 is configured to form the inlet 51 of the liquid cooling plate 50 and is connected to the first through hole 421, and the second communication water channel 532 is configured to form the outlet 52 of the liquid cooling plate 50 and is connected to the second through hole 422.

In this embodiment, the liquid cooling plate 50 and the electrical cover plate 40 are arranged in parallel and spaced from each other, and the heat dissipation panel water nozzle 53 is fastened to the side that is of the liquid cooling plate 50 and that faces the electrical cover plate. In a direction in which the electrical cover plate 40 and the liquid cooling plate 50 are stacked, one end of the heat dissipation panel water nozzle 53 is configured to form the inlet 51 and the outlet 52 of the liquid cooling plate 50, and the other end of the heat dissipation panel water nozzle 53 is configured to communicate with the first through hole 421 and the second through hole 422. In this way, the cooling water is introduced from the electrical cover plate 40 into the liquid cooling plate 50.

In an embodiment, the liquid cooling plate 50 includes one heat exchange substrate 55 and at least one ribbed plate 54. Plane directions of the heat exchange substrate 55 and the ribbed plate 54 are separately parallel to the plane direction of the in-vehicle apparatus 100, and an extension direction of the heat dissipation panel water nozzle 53 is parallel to the height direction of the in-vehicle apparatus 100. The heat exchange substrate 55 and the ribbed plate 54 are configured to be fastened to the connection post 442 through one heat dissipation panel water nozzle 53.

Specifically, the heat dissipation panel water nozzle 53 and the at least one ribbed plate 54 in the liquid cooling plate 50 are respectively arranged on two sides of the heat exchange substrate 55. The ribbed plate 54 and the heat exchange substrate 55 are stacked and fastened in the height direction of the in-vehicle apparatus 100. The ribbed plate 54 is located on a side that is of the heat exchange substrate 55 and that is away from the on-board charger 10. One ribbed plate 54 includes a flow channel groove 541, and a side that is of the flow channel groove 541 and that faces the water cooling radiator 60 is recessed in the height direction of the in-vehicle apparatus 100, that is, a groove opening of the flow channel groove 541 faces the heat exchange substrate 55. The heat exchange substrate 55 encloses the flow channel groove 541 by sealing and attaching to the ribbed plate 54, to form the internal flow channel of the liquid cooling plate 50. A flow path of the flow channel groove 541 overlaps the orthographic projections of the plurality of power modules 14.

In this embodiment, the internal flow channel of the liquid cooling plate 50 protrudes toward a side of the water cooling radiator 60, so that spacings between the liquid cooling plate 50 and the plurality of power modules 14 are not affected, thereby ensuring heat dissipation effect of the liquid cooling plate 50 on the plurality of power modules 14.

In the embodiment shown in the figure, the liquid cooling plate 50 includes two ribbed plates 54. One of the ribbed plates 54 is accommodated in the other ribbed plate 54. The other ribbed plate 54 is configured to be attached to the heat exchange substrate 55 and seal a flow channel hole, and one ribbed plate 54 is configured to form a plurality of protruding ribs, to guide a flow path of the cooling water in the other ribbed plate 54. A quantity and an arrangement manner of the ribbed plates 54 are not limited in the in-vehicle apparatus 100 in this application, provided that the ribbed plates 54 can guide the cooling water to flow, to dissipate heat for the power modules 14.

In an embodiment, the heat exchange substrate 55 is configured to be fastened to the connection post 442 through the heat dissipation panel water nozzle 53. The heat exchange substrate 55 includes two flow channel holes. The two flow channel holes are configured to respectively communicate with the inlet 51 and the outlet 52 of the liquid cooling plate 50. The flow channel hole is configured to penetrate the heat exchange substrate 55 and is connected to the heat dissipation panel water nozzle 53. The heat dissipation panel water nozzle 53 communicates with the internal flow channel of the liquid cooling plate 50 via the flow channel holes. Correspondingly, the heat dissipation panel water nozzle 53 is arranged on a side that is of the heat exchange substrate 55 and that faces the connection post 442 in the height direction of the in-vehicle apparatus 100. The first communication water channel 531 of the heat dissipation panel water nozzle 53 is configured to for communication of one end of the flow channel groove 541 and the first through hole 421 in the connection post 442, and the second communication water channel 532 of the heat dissipation panel water nozzle 53 is configured for communication of the second through hole 422 in the connection post 442 and the other end of the flow channel groove 541.

A contact area between the heat dissipation panel water nozzle 53 and the heat exchange substrate 55 and a contact area between the heat dissipation panel water nozzle 53 and the connection post 442 are large. This facilitates fastening of the heat dissipation panel water nozzle 53 to the heat exchange substrate 55 and the connection post 442, and facilitates sealing and attaching of the heat dissipation panel water nozzle 53 to the heat exchange substrate 55 and the connection post 442.

In an embodiment, the ribbed plate 54 is fastened and sealed to the heat exchange substrate 55 through brazing.

In an embodiment, the heat dissipation panel water nozzle 53 is sealed to the heat exchange substrate 55 through brazing or a sealing ring.

In an embodiment, the heat dissipation panel water nozzle 53 is fastened to the connection post 442 through welding or a fastener, and the heat dissipation panel water nozzle 53 is further sealed to the connection post 442 through welding or a sealing ring.

FIG. 24 is a diagram of a cross-sectional structure of the in-vehicle apparatus 100 according to an embodiment of this application.

In an embodiment, the housing water channel inlet 301 is distributed on an outer side of the electrical accommodation groove 31, the cover plate water channel inlet 401 and the cover plate water channel outlet 402 are distributed on a side that is of the electrical cover plate 40 and that faces the electrical accommodation groove 31, an orientation of the cover plate water channel inlet 401 is opposite to the orientation of the groove opening of the electrical accommodation groove 31, and an orientation of the housing water channel inlet 301 is the same as the orientation of the groove opening of the electrical accommodation groove 31.

In this embodiment, a direction of the cover plate water channel inlet 401 is opposite to the orientation of the groove opening of the electrical accommodation groove 31, a water pipe of the water cooling system communicates with the cover plate water channel inlet 401 in a direction from the integrated housing 30 to the electrical cover plate 40, and the water pipe and the integrated housing 30 are adjacently arranged. In this way, the water pipe does not occupy space on a side that is of the electrical cover plate 40 and that is away from the integrated housing 30, and an overall height of the housing of the in-vehicle apparatus 100 can be controlled. Because the cover plate water channel outlet 402 and the housing water channel inlet 301 face opposite directions, it is convenient for the integrated housing 30 to receive the cooling water via the electrical cover plate 40.

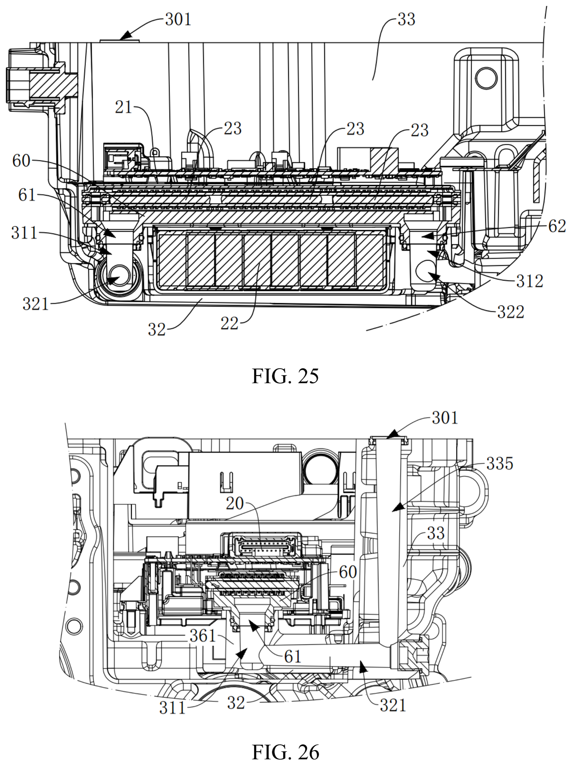

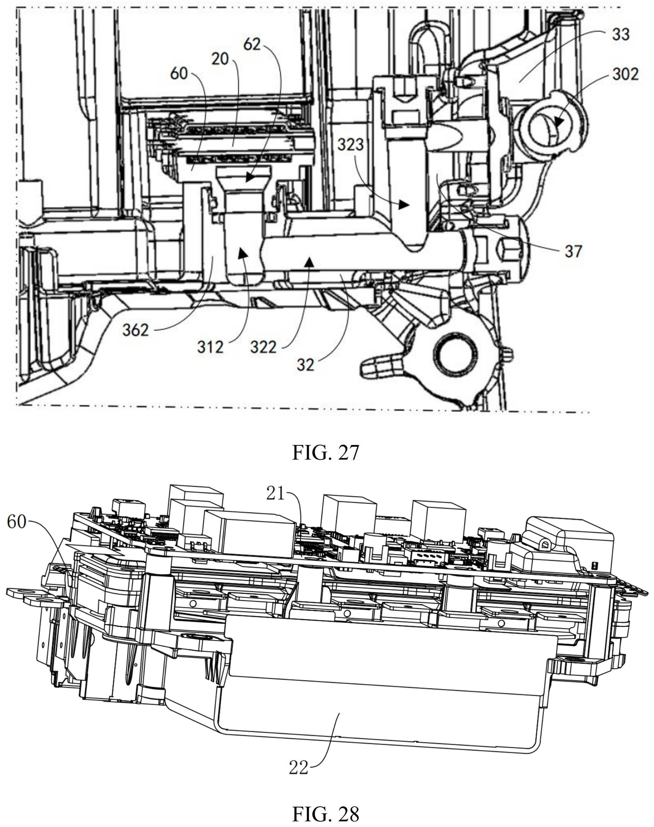

FIG. 25 is a diagram of a cross-sectional structure of the in-vehicle apparatus 100 according to an embodiment of this application, FIG. 26 is a diagram of a cross-sectional structure of the in-vehicle apparatus 100 according to an embodiment of this application, and FIG. 27 is a diagram of a cross-sectional structure of the in-vehicle apparatus 100 according to an embodiment of this application.

In an embodiment, the integrated housing 30 includes the internal water inlet channel and a first groove bottom water channel interface 311, the internal water inlet channel is configured for communication of the housing water channel inlet 301 and the first groove bottom water channel interface 311, and the inlet 61 of the water cooling radiator 60 is configured to receive, via the first groove bottom water channel interface 311, the cooling water input from the housing water channel inlet 301. An orientation of the first groove bottom water channel interface 311 is the same as the orientation of the groove opening of the electrical accommodation groove 31, an orientation of the inlet 61 of the water cooling radiator 60 is opposite to the orientation of the groove opening of the electrical accommodation groove 31, and the inlet 61 of the water cooling radiator 60 is configured to be embedded into the first groove bottom water channel interface 311.

In this embodiment, the internal water inlet channel is configured to deliver the cooling water to the first groove bottom water channel interface 311, and the water cooling radiator 60 is configured to receive, via the first groove bottom water channel interface 311, the cooling water delivered by the integrated housing 30. The inlet 61 of the water cooling radiator 60 is further configured to be embedded into the first groove bottom water channel interface 311, to be connected to the first groove bottom water channel interface 311. The first groove bottom water channel interface 311 is further configured to fasten the water cooling radiator 60.

In an embodiment, the integrated housing 30 includes a second groove bottom water channel interface 312, an internal water outlet channel, and a housing water channel outlet 302, the internal water outlet channel is configured for communication of the second groove bottom water channel interface 312 and the housing water channel outlet 302, and the outlet 62 of the water cooling radiator 60 is configured to deliver the cooling water to the housing water channel outlet 302 via the second groove bottom water channel interface 312. An orientation of the second groove bottom water channel interface 312 is the same as the orientation of the groove opening of the electrical accommodation groove 31, an orientation of the outlet 62 of the water cooling radiator 60 is opposite to the orientation of the groove opening of the electrical accommodation groove 31, and the outlet 62 of the water cooling radiator 60 is configured to be embedded into the second groove bottom water channel interface 312.

In this embodiment, the water cooling radiator 60 is configured to output the cooling water via the integrated housing 30, to implement a circulating heat dissipation function of the internal cooling water. The outlet 62 of the water cooling radiator 60 is configured to be embedded into the second groove bottom water channel interface 312 and connected to the second groove bottom water channel interface 312. The second groove bottom water channel interface 312 is further configured to fasten the water cooling radiator 60. The internal water outlet channel is configured to receive, via the second groove bottom water channel interface 312, the cooling water flowing out of the water cooling radiator 60, and the internal water outlet channel is configured to output the cooling water via the housing water channel outlet 302.

Therefore, the in-vehicle apparatus 100 provided in this application can receive, via the cover plate water channel inlet 401, the cooling water delivered by the water cooling system of the vehicle, separately deliver the cooling water to the water cooling radiator 60 and the liquid cooling plate 50 via the housing internal flow channel, receive the cooling water flowing out of the water cooling radiator 60 and the liquid cooling plate 50 via the housing internal flow channel, and then deliver the cooling water back to the water cooling system via the housing water channel outlet 302 to dissipate heat, thereby dissipating heat for the electrical components accommodated in the electrical accommodation groove 31 in a circulating manner.

In other words, the in-vehicle apparatus 100 provided in this application is configured to communicate with the water cooling system of the electric vehicle 200 via the cover plate water channel inlet 401 and the housing water channel outlet 302, and communicate with the liquid cooling plate 50 and the water cooling radiator 60 in the electrical accommodation groove 31. In this way, the liquid cooling plate 50 and the water cooling radiator 60 respectively dissipate heat for the on-board charger 10 and the motor control unit 20 in a circulating manner.

In an embodiment, the housing water channel inlet 301 and the housing water channel outlet 302 are distributed on a same side outside the electrical accommodation groove 31, and an orientation of the housing water channel outlet 302 is different from an orientation of the housing water channel inlet 301.

In this embodiment, the housing water channel inlet 301 and the cover plate water channel inlet 401 are located on a same side of the electrical accommodation groove 31, and the housing water channel outlet 302 and the cover plate water channel inlet 401 are also located on a same side of the electrical accommodation groove 31. On a same side of the housing of the in-vehicle apparatus 100, water pipes of the water cooling system of the electric vehicle 200 respectively input the cooling water to the housing and receive the cooling water output from the housing. The two water pipes of the water cooling system occupy space on the same side of the housing of the in-vehicle apparatus 100, so that an overall width of the housing of the in-vehicle apparatus 100 can be controlled.

In an embodiment, the integrated housing 30 includes one bottom plate 32 and a plurality of side plates 33. The bottom plate 32 and the side plates 33 are configured to enclose the electrical accommodation groove 31. The bottom plate 32 is configured to form a groove bottom of the electrical accommodation groove 31, and the side plates 33 are configured to form a groove wall of the electrical accommodation groove 31. The bottom plate 32 and the electrical cover plate 40 are spaced from each other in the height direction of the in-vehicle apparatus 100. The bottom plate 32 is located on a side that is of the water cooling radiator 60 and that is away from the electrical cover plate 40. A distance between the bottom plate 32 and the electrical cover plate 40 is a height size of the electrical accommodation groove 31. The side plates 33 are arranged between the bottom plate 32 and the electrical cover plate 40. The side plates 33 are configured to fasten the bottom plate 32 and the electrical cover plate 40. In other words, the bottom plate 32 supports, through the side plates 33, the electrical cover plate 40, and the on-board charger 10 and the liquid cooling plate 50 that are fastened to the electrical cover plate 40.

The bottom plate 32 is configured to fasten the water cooling radiator 60 and the motor control unit 20. Specifically, the bottom plate 32 includes two posts, and the two posts extend toward the water cooling radiator 60 in the height direction of the in-vehicle apparatus 100. The water cooling radiator 60 is embedded into the motor control unit 20 in the height direction of the in-vehicle apparatus 100. The two posts are configured to fasten the water cooling radiator 60, and support the motor control unit 20 through the water cooling radiator 60.

In an embodiment, the orientation of the first groove bottom water channel interface 311 and the orientation of the second groove bottom water channel interface 312 are the same as the orientation of the groove opening of the electrical accommodation groove 31, the orientation of the inlet 61 of the water cooling radiator 60 and the orientation of the outlet 62 of the water cooling radiator 60 are opposite to the orientation of the groove opening of the electrical accommodation groove 31, the inlet 61 of the water cooling radiator 60 is configured to be embedded into the first groove bottom water channel interface 311, and the outlet 62 of the water cooling radiator 60 is configured to be embedded into the second groove bottom water channel interface 312.

In this embodiment, the integrated housing 30 is configured to communicate with the water cooling radiator 60 via the first groove bottom water channel interface 311 and the second groove bottom water channel interface 312. The first groove bottom water channel interface 311 and the second groove bottom water channel interface 312 separately extend from the groove bottom of the electrical accommodation groove 31 to the water cooling radiator 60, and the inlet 61 and the outlet 62 of the water cooling radiator 60 are respectively embedded into the first groove bottom water channel interface 311 and the second groove bottom water channel interface 312. In this way, a sealing fit is formed between an inner wall of the first groove bottom water channel interface 311 and an outer wall of the inlet of the water cooling radiator 60, and between an inner wall of the second groove bottom water channel interface 312 and an outer wall of the outlet of the water cooling radiator 60, to prevent the cooling water from leaking in the electrical accommodation groove 31.

In a description manner, the electrical cover plate 40 and the integrated housing 30 each include an internal flow channel. The cover plate internal flow channel communicates with the internal water inlet channel. The cover plate water channel inlet 401 is configured to communicate with the liquid cooling plate 50 via the cover plate internal flow channel, and the cover plate water channel inlet 401 is further configured to communicate with the water cooling radiator 60 via the cover plate internal flow channel and the internal water inlet channel. The housing water channel outlet 302 is formed on the integrated housing 30, the housing water channel outlet 302 communicates with the water cooling radiator 60 via the internal water outlet channel, and the housing water channel outlet 302 further communicate with the liquid cooling plate 50 via the cover plate internal flow channel and the internal water inlet channel.

Therefore, in the in-vehicle apparatus 100 provided in this application, the electrical cover plate 40 is fastened through the integrated housing 30, to seal the electrical accommodation groove 31. The electrical accommodation groove 31 is configured to accommodate an integrated power supply module, the liquid cooling plate 50, and the water cooling radiator 60. The integrated housing 30 is further configured to fasten the water cooling radiator 60, and the electrical cover plate 40 is further configured to fasten the liquid cooling plate 50 through the columnar reinforcing rib 441, to form a structure in which the water cooling radiator 60, the motor control unit 20, the liquid cooling plate 50, the on-board charger 10, and the electrical cover plate 40 are stacked. In the height direction of the in-vehicle apparatus 100, the water cooling radiator 60 is stacked on the motor control unit 20, and the liquid cooling plate 50 and the electrical cover plate 40 are stacked on two sides of the on-board charger 10.

The liquid cooling plate 50 and the water cooling radiator 60 are separately plate-shaped. The liquid cooling plate 50 and the water cooling radiator 60 that are stacked can reduce an area of the in-vehicle apparatus 100. In other words, an area of the in-vehicle apparatus 100 in this application in the plane direction is small. A contact area between the plate-shaped water cooling radiator 60 and the motor control unit 20 is large, and a contact area between the plate-shaped liquid cooling plate 50 and the on-board charger 10 and a contact area between and the electrical cover plate 40 and the on-board charger 10 are also large. The water cooling radiator 60 and the liquid cooling plate 50 may respectively achieve good heat dissipation effect for the motor control unit 20 and the on-board charger 10.

In this application, the in-vehicle apparatus 100 further uses the integrated housing 30 and the cover plate internal flow channel to form a cooling water channel, to separately communicate with the water cooling radiator 60 and the liquid cooling plate 50. This avoids additionally disposing cooling water pipes inside and outside the electrical accommodation groove 31 of the in-vehicle apparatus 100, and reduces an overall size of the in-vehicle apparatus 100.

In an embodiment, an orthographic projection of the on-board charger 10 in the height direction of the in-vehicle apparatus 100 overlaps the cover plate internal flow channel. In this way, heat can be dissipated for the on-board charger 10 through the cover plate internal flow channel, so that the electrical cover plate 40 and the liquid cooling plate 50 can dissipate heat for the on-board charger 10 from two sides of the on-board charger 10, thereby further improving a heat dissipation capability of the in-vehicle apparatus 100.

In an embodiment, the electrical cover plate 40 is configured to fasten a water channel communication component 70, the water channel communication component 70 includes two ends, one of the two ends of the water channel communication component 70 is configured to enclose the cover plate water channel inlet 401, the other of the two ends of the water channel communication component 70 is configured to receive, via a water pipe, the cooling water delivered by the water cooling system of the electric vehicle 200, and the housing water channel outlet 302 of the integrated housing 30 is configured to deliver the cooling water to the water cooling system of the electric vehicle 200 via the water pipe.

In this embodiment, the electrical cover plate 40 is roughly plate-shaped, and the electrical cover plate 40 communicates with the water pipe of the water cooling system via the water channel communication component 70. This helps implement a sealing fit between the electrical cover plate 40 and the water pipe through the water channel communication component 70. The housing water channel outlet 302 may be constructed in a water nozzle form, to directly communicate with and form a sealing fit with the water pipe of the water cooling system.

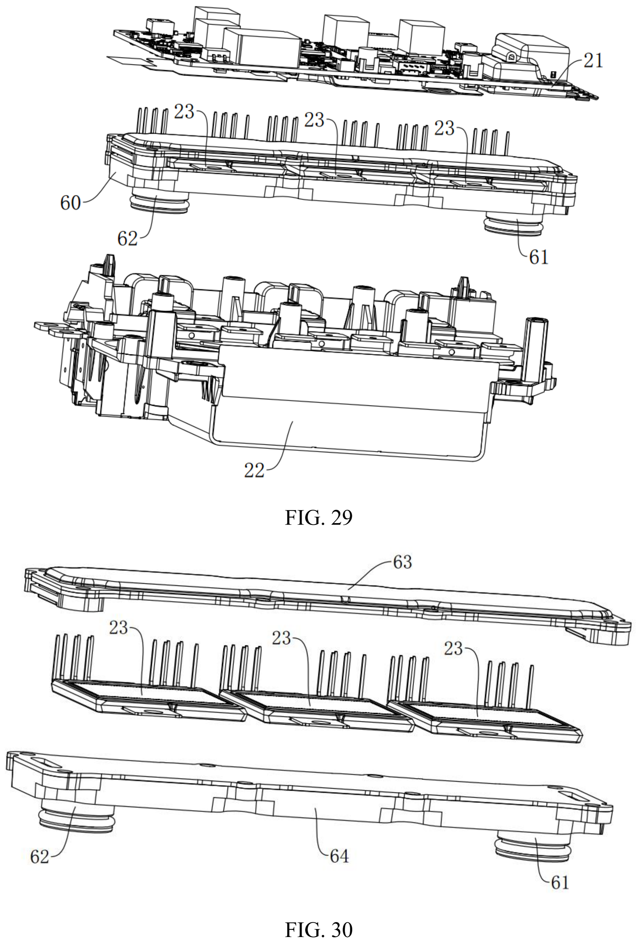

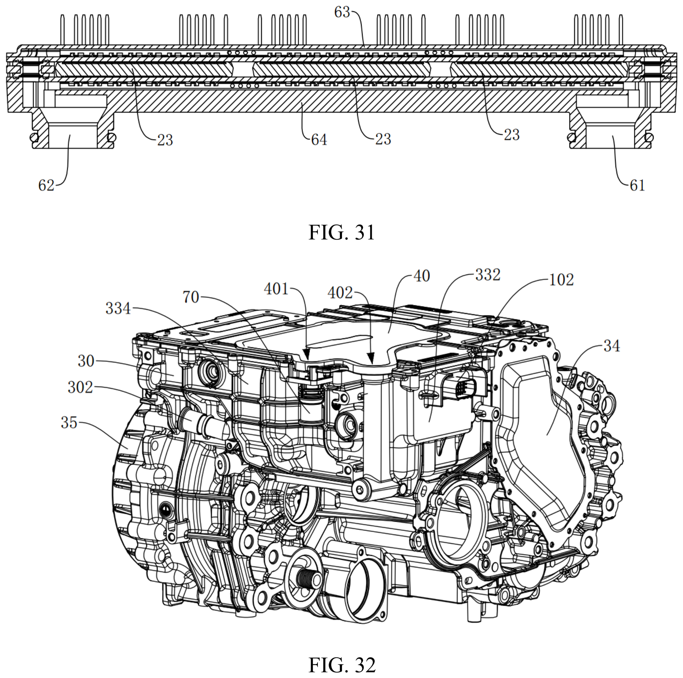

FIG. 28 is a diagram of a partial structure of the in-vehicle apparatus 100 according to an embodiment of this application, FIG. 29 is a diagram of an exploded structure of the in-vehicle apparatus 100 according to an embodiment of this application, FIG. 30 is a diagram of an exploded structure of the in-vehicle apparatus 100 according to an embodiment of this application, and FIG. 31 is a diagram of a cross-sectional structure of the in-vehicle apparatus 100 according to an embodiment of this application.

In an embodiment, the electrical accommodation groove 31 is further configured to accommodate a second circuit board 21, the second circuit board 21 is arranged between the water cooling radiator 60 and the liquid cooling plate 50, the water cooling radiator 60 is configured to fasten the second circuit board 21, and the second circuit board 21 is configured to fasten an electrical component of the motor control unit 20.

In this embodiment, the second circuit board 21 is configured to fasten the electrical component of the motor control unit 20, so that the in-vehicle apparatus 100 in this application has a function of receiving power supplied by the power battery 201 and driving a drive motor. The second circuit board 21 is arranged between the liquid cooling plate 50 and the water cooling radiator 60, so that the liquid cooling plate 50 may dissipate heat for an electrical component fastened to one side of the second circuit board 21, and the water cooling radiator 60 may dissipate heat for an electrical component fastened to the other side of the second circuit board 21. In this way, the in-vehicle apparatus 100 can achieve good heat dissipation effect for the motor control unit 20, to ensure reliable operation of the on-board charger 10.

In this application, the in-vehicle apparatus 100 delivers the cooling water to the liquid cooling plate 50 via the electrical cover plate 40, and then delivers the cooling water to the water cooling radiator 60 via the electrical cover plate 40 and the integrated housing 30. The cooling water first flows through the liquid cooling plate 50 and the cover plate internal flow channel in the housing to dissipate heat for the on-board charger 10, and then flows through the water cooling radiator 60 to dissipate heat for the motor control unit 20. The on-board charger 10 generates a large amount of heat in a process of charging the power battery 201, and in a process of charging the power battery 201, the motor control unit 20 does not operate or generates a small amount of heat when operating. Therefore, the cooling water in the housing preferentially dissipates heat for the on-board charger 10. When the motor control unit 20 receives power supplied by the power battery 201 to drive the electric vehicle 200, the on-board charger 10 does not operate or generates a small amount of heat when operating, a heating temperature of the cooling water flowing through the on-board charger 10 is low, and the cooling water in the housing dissipates more heat for the motor control unit 20. In the in-vehicle apparatus 100 in this application, the housing internal flow channel, the liquid cooling plate 50, and the water cooling radiator 60 are arranged with reference to respective operating characteristics of the on-board charger 10 and the motor control unit 20, to ensure reliable operation of the on-board charger 10 and the motor control unit 20 while reducing a size.

In an embodiment, the electrical component of the motor control unit 20 is configured to control a three-phase inverter circuit in the electrical component of the motor control unit 20, the three-phase inverter circuit includes a bus capacitor module 22, the bus capacitor module 22 is arranged on a side that is of the water cooling radiator 60 and that is away from the second circuit board 21, and the water cooling radiator 60 is configured to fasten the bus capacitor module 22.

In this embodiment, the motor control unit 20 and the water cooling radiator 60 are fastened together to the integrated housing 30, to simplify assembly of the in-vehicle apparatus 100. The water cooling radiator 60 is located between the bus capacitor module 22 and the second circuit board 21, so that two opposite surfaces of the water cooling radiator 60 may respectively dissipate heat for the bus capacitor module 22 and the electrical component on the second circuit board 21.

In an embodiment, the three-phase inverter circuit includes a plurality of second power modules 23, and the plurality of second power modules 23 are arranged between the second circuit board 21 and the bus capacitor module 22. The water cooling radiator 60 includes a first heat dissipation panel 63 and a second heat dissipation panel 64 that are stacked. The first heat dissipation panel 63 and the second heat dissipation panel 64 are connected in parallel between the inlet 61 and the outlet 62 of the water cooling radiator 60. The first heat dissipation panel 63 is arranged between the second power modules 23 and the second circuit board 21. The second heat dissipation panel 64 is arranged between the second power modules 23 and the bus capacitor module 22.

In this embodiment, the water cooling radiator 60 is arranged on two sides of the second power modules 23 through the first heat dissipation panel 63 and the second heat dissipation panel 64, to ensure heat dissipation effect on the second power modules 23, thereby ensuring reliable operation of the motor control unit 20.

In an embodiment, the motor control unit 20 includes a plurality of second power modules 23, one bus capacitor module 22, and one second circuit board 21. The bus capacitor module 22, the plurality of second power modules 23, and the second circuit board 21 are sequentially spaced from each other in the height direction of the in-vehicle apparatus 100. The bus capacitor module 22, the plurality of second power modules 23, and the second circuit board 21 are electrically connected. The plurality of second power modules 23 are configured to convert a direct current of the power battery 201 into an alternating current to drive the drive motor 202.

The bus capacitor module 22 is located between the plurality of second power modules 23 and the bottom plate 32. The bus capacitor module 22 is configured to accommodate a plurality of capacitors of the motor control unit 20, and the bus capacitor module 22 is arranged between the water cooling radiator 60 and the bottom plate 32 in the height direction of the in-vehicle apparatus 100. The bus capacitor module 22 is further arranged between the two posts in the plane direction of the in-vehicle apparatus 100. The second circuit board 21 is configured to mount the electrical component of the motor control unit 20. The second circuit board 21 is arranged between the water cooling radiator 60 and the liquid cooling plate 50 in the height direction of the in-vehicle apparatus 100. In other words, the water cooling radiator 60 and the plurality of second power modules 23 are arranged together between the bus capacitor module 22 and the second circuit board 21 in the height direction of the in-vehicle apparatus 100.

The second power modules 23 are one of main heat sources of the motor control unit 20. The water cooling radiator 60 is mainly configured to dissipate heat for the second power modules 23. Specifically, the water cooling radiator 60 includes two layers of heat dissipation panels. As shown in the figure, the two layers of heat dissipation panels are respectively defined as the first heat dissipation panel 63 and the second heat dissipation panel 64. The first heat dissipation panel 63 and the second heat dissipation panel 64 are spaced from each other in the height direction of the in-vehicle apparatus 100. A gap between the first heat dissipation panel 63 and the second heat dissipation panel 64 is used to accommodate the plurality of second power modules 23 of the motor control unit 20.

The first heat dissipation panel 63 and the second heat dissipation panel 64 each include an internal flow channel. The internal flow channel of the first heat dissipation panel 63 and the internal flow channel of the second heat dissipation panel 64 are connected in parallel between the inlet 61 and the outlet 62 of the water cooling radiator 60. The water cooling radiator 60 can dissipate heat for the second power modules 23 through the two layers of heat dissipation panels on the two sides of the second power modules 23, to improve heat dissipation effect of the water cooling radiator 60 for the second power modules 23.

In the height direction of the in-vehicle apparatus 100, a side surface that is of the first heat dissipation panel 63 and that is away from the second power module 23 faces the second circuit board 21 of the motor control unit 20, and a side surface that is of the second heat dissipation panel 64 and that is away from the second power modules 23 faces the bus capacitor module 22. The first heat dissipation panel 63 and the second heat dissipation panel 64 further respectively dissipate heat for the second circuit board 21 and the bus capacitor module 22, to further improve overall heat dissipation effect of the water cooling radiator 60 on the motor control unit 20.

In other words, the water cooling radiator 60 is arranged on a side that is of the second power modules 23 and that is away from the second circuit board 21 in the height direction of the in-vehicle apparatus 100. The water cooling radiator 60 further includes the first heat dissipation panel 63, and the first heat dissipation panel 63 is configured to be embedded between the second power modules 23 and the second circuit board 21 in the height direction of the in-vehicle apparatus 100. The first heat dissipation panel 63 is configured to separately dissipate heat for the second power modules 23 and the second circuit board 21, to improve heat dissipation effect of the water cooling radiator 60 on the motor control unit 20.

Therefore, the first circuit board 11, the liquid cooling plate 50, the second circuit board 21, the water cooling radiator 60, and the bus capacitor module 22 in the electrical accommodation groove 31 are sequentially stacked between the electrical cover plate 40 and the groove bottom of the electrical accommodation groove 31, the bus capacitor module 22 is configured to fasten the second circuit board 21 and the water cooling radiator 60, and the plurality of second power modules 23 are arranged between the second circuit board 21 and the water cooling radiator 60.

In this embodiment, the motor control unit 20 is arranged between the groove bottom of the electrical accommodation groove 31 and the liquid cooling plate 50. The water cooling radiator 60 is configured to dissipate heat for the plurality of second power modules 23 of the motor control unit 20, to ensure reliable operation of the motor control unit 20. The water cooling radiator 60 is configured to receive, via the housing water channel inlet 301 of the integrated housing 30, the cooling water input by the electrical cover plate 40.

Therefore, the in-vehicle apparatus 100 provided in this application includes one liquid cooling plate 50 and one water cooling radiator 60. The liquid cooling plate 50 is configured to cool the on-board charger 10, and the water cooling radiator 60 is configured to cool the motor control unit 20. In different operating scenarios of the in-vehicle apparatus 100 provided in this application, the on-board charger 10 and the motor control unit 20 separately generate heat continuously. Therefore, dissipating heat for the on-board charger 10 and the motor control unit 20 through the liquid cooling plate 50 and the water cooling radiator 60 respectively can ensure reliable operation of the in-vehicle apparatus 100 provided in this application.

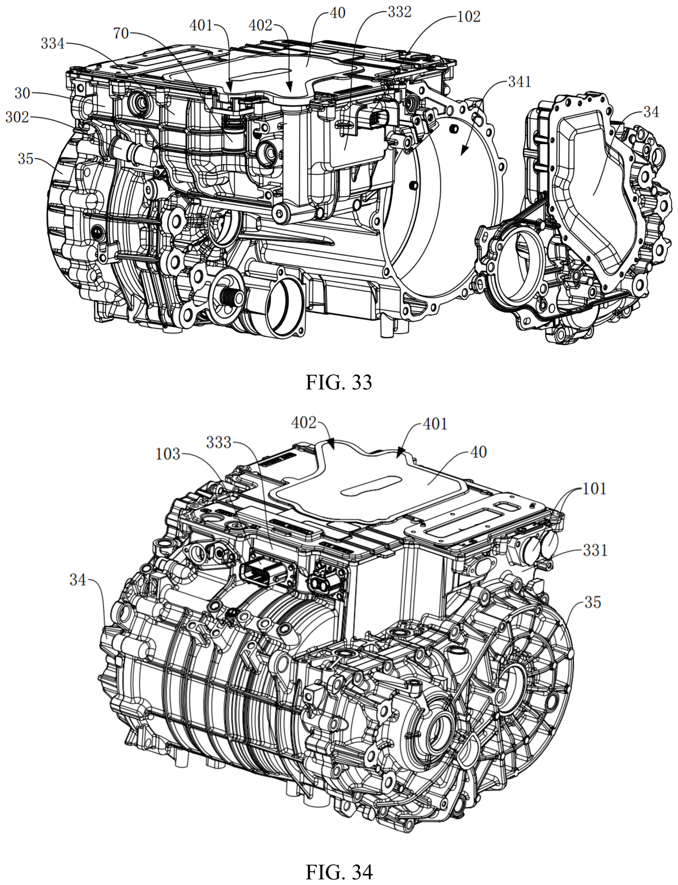

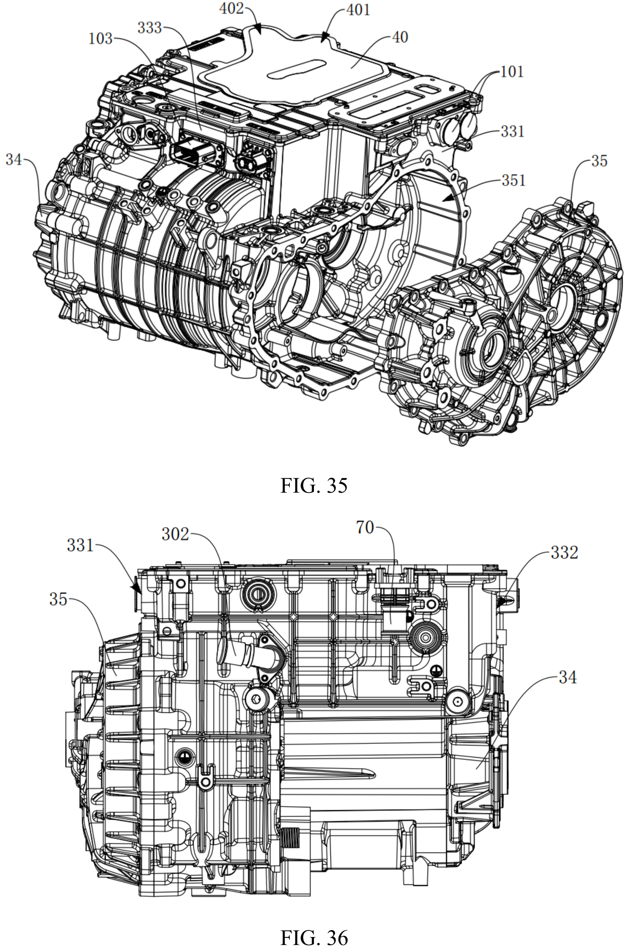

FIG. 32 is a diagram of a structure of the in-vehicle apparatus 100 according to an embodiment of this application, FIG. 33 is a diagram of an exploded structure of the in-vehicle apparatus 100 according to an embodiment of this application, FIG. 34 is a diagram of a structure of the in-vehicle apparatus 100 according to an embodiment of this application, and FIG. 35 is a diagram of an exploded structure of the in-vehicle apparatus 100 according to an embodiment of this application.

In an embodiment, the in-vehicle apparatus 100 further includes a drive motor 202 and a reducer, the housing of the in-vehicle apparatus 100 further includes a motor end cover 34 and a reducer end cover 35, and the integrated housing 30 further includes a motor accommodation groove 341 and a reducer accommodation groove 351. The motor accommodation groove 341 is configured to fasten and accommodate a stator of the drive motor 202, and the motor end cover 34 is configured to enclose the motor accommodation groove 341. The reducer accommodation groove 351 is configured to accommodate a gear set of the reducer, and the reducer end cover 35 is configured to enclose the reducer accommodation groove 351. The motor accommodation groove 341 and the reducer accommodation groove 351 are adjacently arranged in an axial direction of the drive motor 202, an orientation of a groove opening of the motor accommodation groove 341 is opposite to an orientation of a groove opening of the reducer accommodation groove 351, and the orientation of the groove opening of the electrical accommodation groove 31 is perpendicular to the orientation of the groove opening of the motor accommodation groove 341 and the orientation of the groove opening of the reducer accommodation groove 351.

In this embodiment, the integrated housing 30 of the in-vehicle apparatus 100 in this application further includes the motor accommodation groove 341 and the reducer accommodation groove 351, the integrated housing 30 is configured to fasten the stator of the drive motor 202, the motor end cover 34 and the reducer end cover 35 are configured to fasten a transmission shaft of the reducer through a bearing, the motor accommodation groove 341 can accommodate the drive motor 202, and the reducer accommodation groove 351 can accommodate the gear set of the reducer.

Therefore, in this embodiment, the in-vehicle apparatus 100 further integrates a powertrain of the electric vehicle 200. In other words, the in-vehicle apparatus integrates the powertrain, the on-board charger 10, and the motor control unit 20, so that the in-vehicle apparatus 100 in this application is further integrated. The on-board charger 10 is integrated with the motor control unit 20, so that the on-board charger 10 receives power supplied by the power battery 201 and transmits the power to the motor control unit 20. The motor control unit 20 is integrated with the drive motor 202, so that the motor control unit 20 outputs a three-phase alternating current to drive the drive motor 202, and the drive motor 202 outputs a driving force through the reducer to drive the electric vehicle 200.

In an embodiment, the housing of the in-vehicle apparatus 100 and a housing of the drive motor 202 are further of an integrated structure. The integrated housing 30 extends in a direction away from the electrical cover plate 40 and forms the motor accommodation groove 341. An inner wall of the motor accommodation groove 341 is configured to fasten the motor stator of the drive motor 202, and the motor accommodation groove 341 is configured to accommodate the drive motor 202. Such a structure can improve integration of the in-vehicle apparatus 100 and save internal space of the electric vehicle 200.

In an embodiment, the housing of the in-vehicle apparatus 100 and a housing of the reducer are further of an integrated structure. The integrated housing 30 extends in a direction away from the electrical cover plate 40 and forms the reducer accommodation groove 351. The reducer accommodation groove 351 is further configured to accommodate one gear set. The gear set is configured to drive the motor shaft connected to the drive motor 202. In this embodiment, the housing of the in-vehicle apparatus 100 and a housing of the powertrain are of an integrated structure, thereby further improving integration of the in-vehicle apparatus 100 and saving internal space of the electric vehicle 200.

The orientation of the groove opening of the motor accommodation groove 341 is opposite to the orientation of the groove opening of the reducer accommodation groove 351, and the drive motor 202 and the reducer are adjacently arranged in the axial direction of the drive motor 202. In this way, a length size of the in-vehicle apparatus 100 in this application in the axial direction of the drive motor 202 can be reduced. The orientation of the groove opening of the electrical accommodation groove 31 is perpendicular to the orientation of the groove opening of the motor accommodation groove 341 and the orientation of the groove opening of the reducer accommodation groove 351, the electrical cover plate 40 of the in-vehicle apparatus 100 is parallel to the axial direction of the drive motor 202, and is closer to an axis of the drive motor 202. In this way, a height size of the in-vehicle apparatus 100 in this application in a direction perpendicular to the electrical cover plate 40 can be reduced, and an overall size of the in-vehicle apparatus 100 in this application can be further reduced.

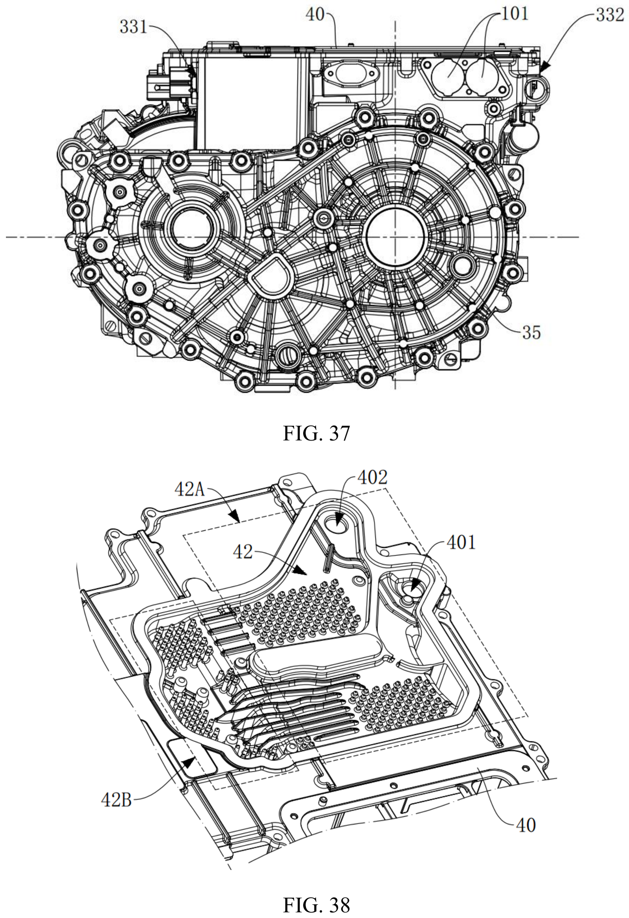

FIG. 36 is a diagram of a structure of the in-vehicle apparatus 100 according to an embodiment of this application, and FIG. 37 is a diagram of a structure of the in-vehicle apparatus 100 according to an embodiment of this application.

In an embodiment, the side plates 33 are configured to form a groove wall of the electrical accommodation groove 31. The groove wall of the electrical accommodation groove 31 includes a first section 331 of the groove wall, a second section 332 of the groove wall, a third section 333 of the groove wall, and a fourth section 334 of the groove wall. The first section 331 of the groove wall and the second section 332 of the groove wall are arranged opposite to each other in the axial direction of the drive motor 202, and the third section 333 of the groove wall and the fourth section 334 of the groove wall are arranged opposite to each other in a direction perpendicular to the axial direction of the drive motor 202. A spacing between the first section 331 of the groove wall and the groove opening of the motor accommodation groove 341 is greater than a spacing between the second section 332 of the groove wall and the groove opening of the motor accommodation groove 341. A spacing between the third section 333 of the groove wall and the motor shaft of the drive motor 202 is less than a spacing between the fourth section 334 of the groove wall and the motor shaft of the drive motor 202. A power battery interface 101 of the in-vehicle apparatus 100 is distributed on the first section 331 of the groove wall. A load power supply interface 102 of the in-vehicle apparatus 100 is distributed on the second section 332 of the groove wall. A control signal interface 103 of the in-vehicle apparatus 100 is distributed on the third section 333 of the groove wall. The housing water channel outlet 302 and the housing water channel inlet 301 are distributed on an outer side of the fourth section 334 of the groove wall.

In this embodiment, the second section 332 of the groove wall and the first section 331 of the groove wall are sequentially arranged in a direction from the motor end cover 34 to the reducer end cover 35. The in-vehicle apparatus 100 receives power supply from the power battery or supplies power to the power battery via the power battery interface 101 on the first section 331 of the groove wall, and the in-vehicle apparatus 100 supplies power to a load of the electric vehicle 200 via the load power supply interface 102 on the second section 332 of the groove wall.

In the direction perpendicular to the axial direction of the drive motor 202, the fourth section 334 of the groove wall is offset toward one side of the drive motor 202 relative to the third section 333 of the groove wall, and the fourth section 334 of the groove wall and an output gear that is in the gear set of the reducer and that is configured to output power are adjacently arranged in the axial direction of the drive motor 202, so that space on a side that is of the drive motor 202 and that faces the output gear of the reducer can be fully utilized for the electrical accommodation groove 31, to reduce an overall width size of the in-vehicle apparatus 100. The in-vehicle apparatus 100 receives or sends a control signal of the electric vehicle 200 through the control signal interface 103 on the third section 333 of the groove wall, and the in-vehicle apparatus 100 receives, via the cover plate water channel inlet 401 on the fourth section 334 of the groove wall, the cooling water delivered by the water cooling system, and delivers the cooling water to the cooling system via the housing water channel outlet 302 on the fourth section 334 of the groove wall.

FIG. 38 is a diagram of a partial structure of the in-vehicle apparatus 100 according to an embodiment of this application.

In an embodiment, the groove bottom of the cooling groove 42 includes two regions. A first region 42A and a second region 42B are defined in FIG. 38. The first region 42A and the second region 42B are adjacently arranged in the first direction 001. Orthographic projections of the plurality of capacitor components and inductor components 12 are accommodated in the first region 42A. Orthographic projections of the electrical components of the secondary-side circuit are accommodated in the second region 42B.

In the height direction of the in-vehicle apparatus 100, a groove depth of the first region 42A of the cooling groove 42 is less than a groove depth of the second region 42B. In this embodiment, in the height direction of the in-vehicle apparatus 100, a thickness value of the small circuit board 13 is less than thickness values of the plurality of capacitor components and inductor components 12, and a surface that is of the small circuit board 13 and that faces the electrical cover plate 40 is lower than surfaces that are of the plurality of capacitor components and inductor components 12 and that face the electrical cover plate 40. Such a structure may cause a larger gap between the electrical components of the secondary-side circuit on the small circuit board 13 and the electrical cover plate 40, and affect heat dissipation effect of the electrical cover plate 40 on the electrical components of the secondary-side circuit.

In this embodiment, a groove bottom of the second region 42B in the cooling groove 42 of the electrical cover plate 40 is disposed to sink toward the small circuit board 13, to reduce a spacing between the cover plate internal flow channel and the electrical components of the secondary-side circuit, and ensure that the electrical cover plate 40 has better heat dissipation effect on the electrical components of the secondary-side circuit.

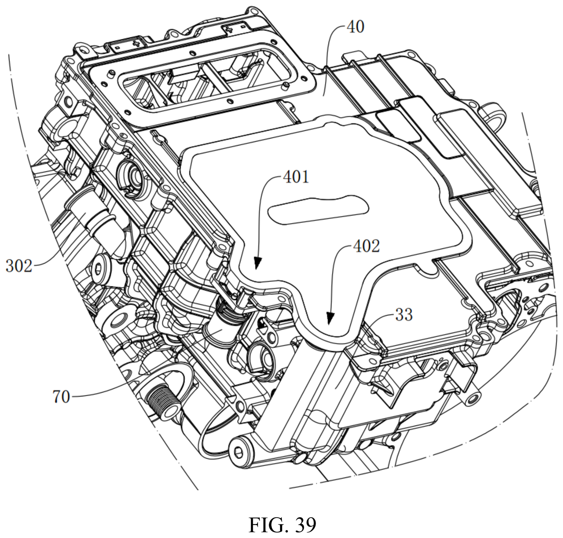

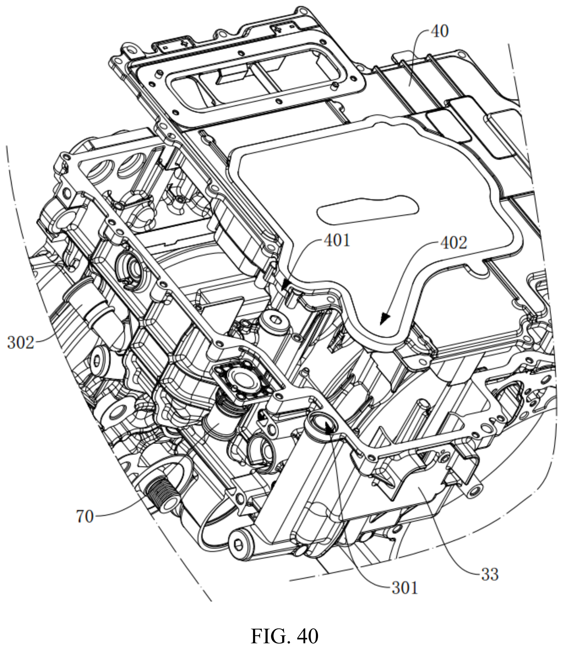

FIG. 39 is a diagram of a partial structure of the in-vehicle apparatus 100 according to an embodiment of this application, and FIG. 40 is a diagram of a partial exploded structure of the in-vehicle apparatus 100 according to an embodiment of this application.

In an embodiment, the internal water inlet channel includes an internal flow channel of the side plate 33 and an internal flow channel of the bottom plate 32. The side plate 33 is configured to fasten the bottom plate 32 and the electrical cover plate 40, and the internal flow channel of the side plate 33 is configured for communication of the cover plate water channel outlet 402 and the internal flow channel of the bottom plate 32. Specifically, the side plate 33 includes a top surface facing the electrical cover plate 40, and the top surface of the side plate 33 is configured to be attached and fastened to a bottom surface of the electrical cover plate 40. The top surface of the side plate 33 includes the housing water channel inlet 301.

In embodiments of this application, the internal flow channel for communication of the side plate 33 and the housing water channel inlet 301 is defined as a first communication hole 335, that is, the first communication hole 335 is constructed as a section of the internal water inlet channel. The first communication hole 335 is a blind hole, the first communication hole 335 extends from the housing water channel inlet 301 to the bottom plate 32 in the height direction of the in-vehicle apparatus 100, and the first communication hole 335 forms a part of the internal flow channel of the side plate 33 and is configured to communicate with the internal flow channel of the bottom plate 32.

In the height direction of the in-vehicle apparatus 100, the housing water channel inlet 301 is configured to be aligned with the cover plate water channel outlet 402, for communication of the cover plate internal flow channel to the internal water inlet channel. Therefore, the internal flow channel of the bottom plate 32 further communicates with the cover plate water channel inlet 401 of the electrical cover plate 40 via the first communication hole 335.

The top surface of the side plate 33 is sealed to the bottom surface of the electrical cover plate 40. In an embodiment, outer edges of the housing water channel inlet 301 and the cover plate water channel outlet 402 include one sealing ring. The sealing ring is partially embedded into the top surface of the side plate 33 or partially embedded into the bottom surface of the electrical cover plate 40. When the electrical cover plate 40 is attached to the top surface of the side plate 33, the top surface of the side plate 33 is sealed to the bottom surface of the electrical cover plate 40 by squeezing the sealing ring for deformation. In this application, the in-vehicle apparatus 100 synchronously implements a sealed connection between the cover plate internal flow channel and the internal water inlet channel by assembling the electrical cover plate 40 and the integrated housing 30.

The bottom plate 32 supports the water cooling radiator 60 and the motor control unit 20 through the two posts. The first groove bottom water channel interface 311 and the second groove bottom water channel interface 312 are respectively formed inside the two posts. The internal flow channel of the bottom plate 32 is further configured for communication of the inlet 61 and the outlet 62 of the water cooling radiator 60 via the first groove bottom water channel interface 311 and the second groove bottom water channel interface 312. Specifically, a top surface that is of each post and that faces the water cooling radiator 60 forms a groove bottom water channel interface. The groove bottom water channel interface is a blind hole, the groove bottom water channel interface is configured to extend from the top surface of the post toward the bottom plate 32 in the height direction of the in-vehicle apparatus 100, and the internal flow channel of the bottom plate 32 is configured to separately communicate with two groove bottom water channel interfaces.

A groove bottom water channel interface of one post is configured to accommodate and fasten the inlet 61 of the water cooling radiator 60, and a groove bottom water channel interface of the other post is configured to accommodate and fasten the outlet 62 of the water cooling radiator 60. Specifically, for ease of description, the two posts of the bottom plate 32 are defined as a first post 361 and a second post 362. The first post 361 includes the first groove bottom water channel interface 311, and the second post 362 includes the second groove bottom water channel interface 312. The first post 361 is configured to communicate with the inlet 61 of the water cooling radiator 60 via the first groove bottom water channel interface 311, and the second post 362 is configured to communicate with the outlet 62 of the water cooling radiator 60 via the second groove bottom water channel interface 312.

The bottom plate 32 includes two communication holes. In embodiments of this application, the two communication holes of the bottom plate 32 are defined as a second communication hole 321 and a third communication hole 322. The second communication hole 321 and the third communication hole 322 are blind holes, and the second communication hole 321 and the third communication hole 322 are configured to separately extend from a side surface of the bottom plate 32 to the inside of the bottom plate 32. In an embodiment, the second communication hole 321 and the third communication hole 322 extend from a side surface that is of the bottom plate 32 and that is close to the side plate 33 having the first communication hole 335 to the inside of the bottom plate 32. Extension directions of the second communication hole 321 and the third communication hole 322 are parallel to the first direction 001.

The second communication hole 321 and the third communication hole 322 form the internal flow channel of the bottom plate 32. The second communication hole 321 is configured to form a section of the internal water inlet channel, and the third communication hole 322 is configured to form a section of the internal water outlet channel. The second communication hole 321 is configured for communication of the first communication hole 335 and the first groove bottom water channel interface 311, and the third communication hole 322 is configured for communication of the second groove bottom water channel interface 312 and the housing water channel outlet 302.

Specifically, the second communication hole 321 extends in the first direction 001, and the first groove bottom water channel interface 311 and the first communication hole 335 separately extend in the height direction of the in-vehicle apparatus 100. The cooling water that enters the first communication hole 335 from the cover plate internal flow channel enters the inlet 61 of the water cooling radiator 60 via the second communication hole 321 and the first groove bottom water channel interface 311 in sequence.

The second groove bottom water channel interface 312 extends in the height direction of the in-vehicle apparatus 100, the third communication hole 322 extends in the first direction 001, and the cooling water flowing out of the outlet 62 of the water cooling radiator 60 flows into the third communication hole 322 via the second groove bottom water channel interface 312, and then flows out of the internal water outlet channel from the housing water channel outlet 302.

The first groove bottom water channel interface 311, the second groove bottom water channel interface 312, and the first communication hole 335 may be respectively formed through processing a top surface of the first post 361, a top surface of the second post 362, and the top surface of the side plate 33 downward. The second communication hole 321 and the third communication hole 322 are formed through processing on a side surface that is of the bottom plate 32 and that is close to the side plate 33 toward the inside of the bottom plate 32. The integrated housing 30 further includes a plug, and the plug is configured to seal an opening formed by the second communication hole 321 on the side surface of the bottom plate 32, to prevent the cooling water from leaking from the side surface of the bottom plate 32.

In an embodiment, the opening formed by the third communication hole 322 on the side surface of the bottom plate 32 may be constructed as the housing water channel outlet 302 of the in-vehicle apparatus 100. In another embodiment, the housing water channel outlet 302 is disposed on a side surface of the side plate 33, and the third communication hole 322 further communicates with the housing water channel outlet 302 via the internal flow channel of the side plate 33. In other words, the side plate 33 includes the housing water channel outlet 302, and the housing water channel outlet 302 is configured to communicate with the water cooling radiator 60 via the internal flow channel of the side plate 33 and the internal flow channel of the bottom plate 32.

In the illustrated embodiment, the bottom plate 32 includes a boss 37. The boss 37 is located between the side plate 33 and the water cooling radiator 60 in the first direction 001. The boss 37 is connected to the side plate 33. The boss 37 includes two communication holes. One of the communication holes extends in the first direction 001 and penetrates the side plate 33. The communication hole is used as the housing water channel outlet 302 of the in-vehicle apparatus 100. The other communication hole extends in the height direction of the in-vehicle apparatus 100, and the other communication hole is configured for communication of the third communication hole 322 and the housing water channel outlet 302.

In the figure, the other communication hole that is in the boss 37 and that is configured for communication of the third communication hole 322 and the housing water channel outlet 302 is defined as a fourth communication hole 323. The fourth communication hole 323 is configured to form a section of the internal water outlet channel. The fourth communication hole 323 may be formed by processing a top surface of the boss 37 downward, and the housing water channel outlet 302 is formed by processing the side surface of the side plate 33 toward the boss 37.

In an embodiment, the integrated housing 30 includes two other plugs. One of the other two plugs is configured to seal the opening formed by the third communication hole 322 on the side surface of the bottom plate 32, and the other of the other two plugs is configured to seal an opening formed by the fourth communication hole 323 on the top surface of the boss 37.

Therefore, the internal water inlet channel can communicate with the internal flow channel of the bottom plate 32 via the internal flow channel of the side plate 33, and the water cooling radiator 60 is connected in series to the internal flow channel of the bottom plate 32. The internal flow channel of the bottom plate 32 further communicates with the housing water channel outlet 302 of the in-vehicle apparatus 100 via the internal flow channel of the side plate 33. Because an internal flow channel of each section of the bottom plate 32 and an internal flow channel of each section of the side plate 33 respectively extend inward from an exposed surface of the bottom plate 32 or an exposed surface of the side plate 33, the internal flow channel of the bottom plate 32 and the internal flow channel of the side plate 33 may be formed through processing, to reduce processing costs of the integrated housing 30. In addition, openings of the second communication hole 321, the third communication hole 322, and the housing water channel outlet 302 are separately formed on a side surface that is of the side plate 33 and that is away from the electrical accommodation groove 31, so that a risk of cooling water leakage in the electrical accommodation groove 31 can be avoided.

In some embodiments, internal flow channels of some sections of the bottom plate 32 and internal flow channels of some sections of the side plate 33 may be integrally formed through casting with the integrated housing 30, to improve sealing performance of the internal flow channels in the integrated housing 30, and avoid cooling water leakage in the integrated housing 30.

Based on the foregoing expansion of the embodiments of the integrated housing 30, in an embodiment, a specific flow path of the cooling water in the integrated housing 30 is as follows: The cooling water sequentially flows into the second communication hole 321, the first groove bottom water channel interface 311, and the inlet 61 via the first communication hole 335. After the cooling water dissipates heat for the motor control unit 20 in the water cooling radiator 60, the cooling water sequentially flows into the second groove bottom water channel interface 312, the third communication hole 322, and the fourth communication hole 323 via the outlet 62, and finally flows out of the housing water channel outlet 302. Therefore, the water cooling radiator 60 is connected in series in the internal flow channel of the bottom plate 32. The cooling water flowing into the internal flow channel of the side plate 33 may flow into the water cooling radiator 60 via the first groove bottom water channel interface 311, and then flow out of the water cooling radiator 60 via the second groove bottom water channel interface 312, so that the water cooling radiator 60 continuously dissipates heat for the motor control unit 20.

In embodiments of this application, the internal water inlet channel may include the first communication hole 335 and the second communication hole 321, and the internal water outlet channel may include the third communication hole 322 and the fourth communication hole 323.

It is clear that persons skilled in the art can make various modifications and variations to this application without departing from the scope of this application. This application is intended to cover these modifications and variations of this application provided that they fall within the scope of protection defined by the following claims and their equivalent technologies. The foregoing embodiments are merely intended for describing the technical solutions of this application other than limiting this application. Although this application is described in detail with reference to the foregoing embodiments, persons of ordinary skill in the art should understand that modifications may still be made to the technical solutions described in the foregoing embodiments or equivalent replacements may still be made to some technical features thereof, without departing from the scope of the technical solutions of embodiments of this application.

## Claims

1. An in-vehicle apparatus, wherein a housing of the in-vehicle apparatus comprises an integrated housing and an electrical cover plate, the integrated housing comprises an electrical accommodation groove, the electrical cover plate is configured to enclose the electrical accommodation groove, the electrical accommodation groove is configured to accommodate a liquid cooling plate and a water cooling radiator, the electrical cover plate, the liquid cooling plate, and the water cooling radiator are sequentially stacked, the electrical cover plate is configured to fasten the liquid cooling plate, and the electrical accommodation groove is configured to fasten the water cooling radiator;
the integrated housing comprises a housing water channel inlet and an internal water inlet channel, the electrical cover plate comprises a cover plate water channel inlet, a cover plate internal flow channel, and a cover plate water channel outlet, the cover plate internal flow channel is configured to: receive cooling water via the cover plate water channel inlet, and deliver the cooling water to the housing water channel inlet via the cover plate water channel outlet, and the cover plate internal flow channel is further configured to deliver the cooling water to an inlet of the liquid cooling plate; and
the internal water inlet channel is configured to receive the cooling water via the housing water channel inlet, and deliver the cooling water to an inlet of the water cooling radiator.

2. The in-vehicle apparatus according to claim 1, wherein the electrical accommodation groove is further configured to accommodate a first circuit board, the first circuit board is arranged between the liquid cooling plate and the electrical cover plate, the electrical cover plate is configured to fasten the first circuit board, and the first circuit board is configured to fasten an electrical component of an on-board charger.

3. The in-vehicle apparatus according to claim 2, wherein a side that is of the first circuit board and that faces the liquid cooling plate is configured to fasten a plurality of power modules in the electrical component of the on-board charger, a projection of the liquid cooling plate on the first circuit board covers the plurality of power modules, and an outlet of the liquid cooling plate is configured to deliver the cooling water to the cover plate internal flow channel; and
a side that is of the first circuit board and that faces the electrical cover plate is configured to fasten a capacitor component and an inductor component of the on-board charger, and a projection of the cover plate internal flow channel on the first circuit board covers at least a part of the capacitor component and the inductor component.

4. The in-vehicle apparatus according to any one of claims 1 to 3, wherein the electrical cover plate comprises a cooling groove and a cooling cover plate, the cooling groove is distributed on a side that is of the electrical cover plate and that is away from the electrical accommodation groove, the cooling cover plate is configured to enclose the cooling groove to form the cover plate internal flow channel, a groove bottom of the cooling groove comprises a third through hole, a fourth through hole, and a first separation protrusion, the third through hole is configured to communicate with the cover plate water channel inlet, the fourth through hole is configured to communicate with the cover plate water channel outlet, and the first separation protrusion is configured to separate the third through hole from the fourth through hole to form a U-shaped flow channel.

5. The in-vehicle apparatus according to claim 4, wherein the groove bottom of the cooling groove comprises a first through hole, a second through hole, and a second separation protrusion, the first through hole and the second through hole separately penetrate the groove bottom of the cooling groove, the first through hole is configured to communicate with the inlet of the liquid cooling plate, the second through hole is configured to communicate with the outlet of the liquid cooling plate, the second separation protrusion is configured to separate the first through hole from the second through hole, the third through hole and the first through hole are arranged between the first separation protrusion and the second separation protrusion, the first through hole and the third through hole are arranged on one side of the second separation protrusion, and the second through hole is arranged on the other side of the second separation protrusion.

6. The in-vehicle apparatus according to claim 5, wherein the electrical cover plate comprises a connection post, the connection post extends toward the liquid cooling plate, a surface that is of the connection post and that faces the liquid cooling plate comprises a groove, the groove is configured to accommodate a heat dissipation panel water nozzle of the liquid cooling plate, the first through hole penetrates the groove bottom of the cooling groove and a groove bottom of the groove and is connected to the inlet of the liquid cooling plate, and the second through hole penetrates the groove bottom of the cooling groove and the groove bottom of the groove and is connected to the outlet of the liquid cooling plate.

7. The in-vehicle apparatus according to any one of claims 1 to 6, wherein the housing water channel inlet is distributed on an outer side of the electrical accommodation groove, the cover plate water channel inlet and the cover plate water channel outlet are distributed on a side that is of the electrical cover plate and that faces the electrical accommodation groove, an orientation of the cover plate water channel inlet is opposite to an orientation of a groove opening of the electrical accommodation groove, and an orientation of the housing water channel inlet is the same as the orientation of the groove opening of the electrical accommodation groove.

8. The in-vehicle apparatus according to any one of claims 1 to 7, wherein the integrated housing comprises the internal water inlet channel and a first groove bottom water channel interface, the internal water inlet channel is configured for communication of the housing water channel inlet and the first groove bottom water channel interface, and the inlet of the water cooling radiator is configured to receive, via the first groove bottom water channel interface, the cooling water input from the housing water channel inlet; and
an orientation of the first groove bottom water channel interface is the same as the orientation of the groove opening of the electrical accommodation groove, an orientation of the inlet of the water cooling radiator is opposite to the orientation of the groove opening of the electrical accommodation groove, and the inlet of the water cooling radiator is configured to be embedded into the first groove bottom water channel interface.

9. The in-vehicle apparatus according to any one of claims 1 to 8, wherein the integrated housing comprises a second groove bottom water channel interface, an internal water outlet channel, and a housing water channel outlet, the internal water outlet channel is configured for communication of the second groove bottom water channel interface and the housing water channel outlet, and an outlet of the water cooling radiator is configured to deliver the cooling water to the housing water channel outlet via the second groove bottom water channel interface; and
an orientation of the second groove bottom water channel interface is the same as the orientation of the groove opening of the electrical accommodation groove, an orientation of the outlet of the water cooling radiator is opposite to the orientation of the groove opening of the electrical accommodation groove, and the outlet of the water cooling radiator is configured to be embedded into the second groove bottom water channel interface.

10. The in-vehicle apparatus according to claim 9, wherein the housing water channel inlet and the housing water channel outlet are distributed on a same side outside the electrical accommodation groove, and an orientation of the housing water channel outlet is different from an orientation of the housing water channel inlet.

11. The in-vehicle apparatus according to any one of claims 1 to 10, wherein the electrical accommodation groove is further configured to accommodate a second circuit board, the second circuit board is arranged between the water cooling radiator and the liquid cooling plate, the water cooling radiator is configured to fasten the second circuit board, and the second circuit board is configured to fasten an electrical component of a motor control unit.

12. The in-vehicle apparatus according to claim 11, wherein the electrical component of the motor control unit is configured to control a three-phase inverter circuit in the electrical component of the motor control unit, the three-phase inverter circuit comprises a bus capacitor module, the bus capacitor module is arranged on a side that is of the water cooling radiator and that is away from the second circuit board, and the water cooling radiator is configured to fasten the bus capacitor module.

13. The in-vehicle apparatus according to claim 12, wherein the three-phase inverter circuit comprises a plurality of second power modules, and the plurality of second power modules are arranged between the second circuit board and the bus capacitor module; and
the water cooling radiator comprises a first heat dissipation panel and a second heat dissipation panel that are stacked, the first heat dissipation panel and the second heat dissipation panel are connected in parallel between the inlet and the outlet of the water cooling radiator, the first heat dissipation panel is arranged between the second power modules and the second circuit board, and the second heat dissipation panel is arranged between the second power modules and the bus capacitor module.

14. The in-vehicle apparatus according to any one of claims 1 to 13, wherein the in-vehicle apparatus further comprises a drive motor and a reducer, the housing of the in-vehicle apparatus further comprises a motor end cover and a reducer end cover, the integrated housing further comprises a motor accommodation groove and a reducer accommodation groove, the motor accommodation groove is configured to fasten and accommodate a stator of the drive motor, the motor end cover is configured to enclose the motor accommodation groove, the reducer accommodation groove is configured to accommodate a gear set of the reducer, and the reducer end cover is configured to enclose the reducer accommodation groove;
the motor accommodation groove and the reducer accommodation groove are adjacently arranged in an axial direction of the drive motor, an orientation of a groove opening of the motor accommodation groove is opposite to an orientation of a groove opening of the reducer accommodation groove, and the orientation of the groove opening of the electrical accommodation groove is perpendicular to the orientation of the groove opening of the motor accommodation groove and the orientation of the groove opening of the reducer accommodation groove; and
a groove wall of the electrical accommodation groove comprises a first section of the groove wall, a second section of the groove wall, a third section of the groove wall, and a fourth section of the groove wall, the first section of the groove wall and the second section of the groove wall are arranged opposite to each other in the axial direction of the drive motor, the third section of the groove wall and the fourth section of the groove wall are arranged opposite to each other in a direction perpendicular to the axial direction of the drive motor, a spacing between the first section of the groove wall and the groove opening of the motor accommodation groove is greater than a spacing between the second section of the groove wall and the groove opening of the motor accommodation groove, a spacing between the third section of the groove wall and a motor shaft of the drive motor is less than a spacing between the fourth section of the groove wall and the motor shaft of the drive motor, a power battery interface of the in-vehicle apparatus is distributed on the first section of the groove wall, a load power supply interface of the in-vehicle apparatus is distributed on the second section of the groove wall, a control signal interface of the in-vehicle apparatus is distributed on the third section of the groove wall, and the housing water channel outlet and the housing water channel inlet are distributed on an outer side of the fourth section of the groove wall.

15. An electric vehicle, wherein the electric vehicle comprises a power battery and the in-vehicle apparatus according to any one of claims 1 to 14, and the in-vehicle apparatus is configured to charge the power battery or drive wheels by using power supplied by the power battery.
